(19) Europäisches Patentamt / European Patent Office / Office européen des brevets

(11) **EP 4 122 351 A1**

(12) **EUROPEAN PATENT APPLICATION**
published in accordance with Art. 153(4) EPC

(43) Date of publication:
**25.01.2023 Bulletin 2023/04**

(21) Application number: **21771571.3**

(22) Date of filing: **18.03.2021**

(51) International Patent Classification (IPC):
**A44B 18/00** (2006.01) **B32B 27/00** (2006.01)
**B32B 27/32** (2006.01) **B65D 65/00** (2006.01)
**C08F 210/14** (2006.01) **C09J 123/02** (2006.01)
**C09J 123/20** (2006.01) **C08J 5/00** (2006.01)
**C09J 7/26** (2018.01) **C09J 7/38** (2018.01)
**H05K 1/02** (2006.01)

(52) Cooperative Patent Classification (CPC):
**A44B 18/00; B32B 27/00; B32B 27/32;
B65D 65/00; C08F 210/14; C08J 5/00; C09J 7/26;
C09J 7/38; C09J 123/02; C09J 123/20; H05K 1/02**

(86) International application number:
**PCT/JP2021/011183**

(87) International publication number:
**WO 2021/187595 (23.09.2021 Gazette 2021/38)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.03.2020 JP 2020048764
11.08.2020 JP 2020135699
22.10.2020 JP 2020177619**

(71) Applicant: **Mitsui Chemicals, Inc.
Tokyo 105-7122 (JP)**

(72) Inventors:
• **NISHIKAWA Shigeo**
  **Tokyo 105-7122 (JP)**
• **TAHARA Syuji**
  **Sodegaura-shi, Chiba 299-0265 (JP)**
• **SHINADA Tsunetoshi**
  **Sodegaura-shi, Chiba 299-0265 (JP)**
• **UEDA Takeshi**
  **Tokyo 105-7122 (JP)**

(74) Representative: **Hoffmann Eitle
Patent- und Rechtsanwälte PartmbB
Arabellastraße 30
81925 München (DE)**

(54) **SELF-ADHESIVE SHEET**

(57) Provided is a self-adhesive sheet including a 4-methyl-1-pentene-based polymer. In the self-adhesive sheet, it is preferable that at least one or more temperatures showing a local maximum value of a loss tangent (tan $\delta$), which is obtained by dynamic viscoelasticity measurement under conditions of a temperature rising rate of 4 °C/min, a frequency of 1.59 Hz, and a strain amount of 0.1%, are present in a range of 10°C or higher and 100°C or lower, the local maximum value of the loss tangent is 0.5 or more and 3.5 or less, an arithmetic average roughness Ra on one surface of the self-adhesive sheet is in a range of 0.01 to 10 um, and a ten-point average roughness Rz is in a range of 0.1 to 50 um.

Fig.17

EP 4 122 351 A1

**Description**

TECHNICAL FIELD

The present invention relates to a self-adhesive sheet. More specifically, the present invention relates to a self-adhesive sheet, a wiring board using the same, a sealing member, and the like.

BACKGROUND ART

Conventionally, a self-adhesive film that is adherable by the adhesiveness of the film itself without using an adhesive has been known. For example, Patent Document 1 discloses a self-adhesive sheet containing a specific elastomer and used as an exterior material of a wire harness for an automobile.
On the other hand, electronic devices having deformability such as bending, and stretching and contraction have been developed (for example, Patent Documents 2 and 3) .

RELATED DOCUMENT

PATENT DOCUMENT

[Patent Document 1] Japanese Unexamined Patent Publication No. 2018-70676
[Patent Document 2] Japanese Unexamined Patent Publication No. 2020-47818
[Patent Document 3] Japanese Unexamined Patent Publication No. 2020-10052

SUMMARY OF THE INVENTION

TECHNICAL PROBLEM

Incidentally, a general touch fastener is used by facing a surface with raised hooks and a surface with dense raised loops, and accordingly can be repeatedly attached and detached.
However, the detachable surface of the touch fastener has problems that the suction force is reduced due to matter attached during repeated use, and the loop portion is damaged or deteriorated by the hook. In addition, since a relatively large area is required, there are restrictions on the design, which makes it unsuitable for a stylish design.
Therefore, the present inventors have focused on using self-adhesive sheets in an overlapping manner like a touch fastener. As a result of repeated research, the present inventors have found that in the conventional self-adhesive sheet as described in Patent Document 1, there is room for improvement in fixability in a planar direction.
That is, a first invention has been made in view of the above circumstances, and provides a self-adhesive sheet, a fixing member, and a touch fastener that have improved fixability.
On the other hand, in recent years, among electronic devices having deformability, wearable devices and the like that are used by being attached to a living body have attracted much attention. Wearable devices are required to have elastic deformability and stretchability such as flexibility and stretchability in addition to weight reduction, thickness reduction, and miniaturization. However, a wearable device that can be satisfactorily brought into close contact with a living body while achieving weight reduction, thickness reduction, and miniaturization has not yet been developed.
The present inventors have focused on the development of a wiring board that has good adhesion to a living body and the like. As a result of repeated research, the present inventors have found that by using a sheet satisfying specific conditions, good adhesion to the living body can be obtained. That is, it has been found that by using the predetermined loss tangent of a 4-methyl-1-pentene-based polymer contained in a sheet as an index and controlling the loss tangent, good viscosity is exhibited at the environmental temperature at which a wiring board is used, and as a result, appropriate shape followability and adhesion can be obtained as the wiring board, and a second invention has been completed.
In addition, it is known that various objects to be sealed can be sealed by using a sealing member including an opening and closing portion. Examples of the object to be sealed include foods such as fruits, syringes, drugs, medical devices such as medical tubes, affected portions such as wounds of patients, and patients with infectious diseases requiring quarantine.
In medical sites, food handling sites, and the like, there may be a case where a specific area is sealed with a film or the like in order to prevent the invasion or leakage of bacteria.
For example, in the food field, in order to prevent the invasion of bacteria, insects, and the like from the outside, the inside of the sealing member may be pressurized to prevent the invasion.

For example, in the medical field, when accepting a patient with an infectious disease, from the viewpoint of quarantine from the outside in order to prevent infection, sealing may be performed with an isolation film having sealing performance or the like, the inside may be negatively pressurized and isolated to prevent the leakage and diffusion of bacteria.

In the above example, there is a case where the invasion or leakage of bacteria cannot be prevented due to the poor sealing performance inside the sealing member.

In particular, when the opening and closing portion is in a closed state, it is difficult to enhance the airtightness of the opening and closing portion.

Therefore, a problem to be solved by a third invention is to provide a sealing member having excellent airtightness of an opening and closing portion in an environment close to normal temperature.

SOLUTION TO PROBLEM

As a result of intensive studies to realize a self-adhesive sheet having excellent fixability in a planar direction, in a self-adhesive sheet containing a 4-methyl-1-pentene-based polymer, the present inventors have first found the effectiveness of specifying the surface roughness of the self-adhesive sheet main body while using the predetermined loss tangent of the 4-methyl-1-pentene-based polymer as an index and controlling the loss tangent, and have completed the present invention.

That is, according to the present invention, a first invention, a second invention, and a third invention shown below are provided.

[1] A self-adhesive sheet including:

a 4-methyl-1-pentene-based polymer,
in which in the self-adhesive sheet, at least one or more temperatures showing a local maximum value of a loss tangent (tan $\delta$), which is obtained by dynamic viscoelasticity measurement under conditions of a temperature rising rate of 4 °C/min, a frequency of 1.59 Hz, and a strain amount of 0.1%, are present in a range of 10°C or higher and 100°C or lower, and the local maximum value of the loss tangent is 0.5 or more and 3.5 or less, and
an arithmetic average roughness Ra on one surface of the self-adhesive sheet is in a range of 0.01 to 10 um, and a ten-point average roughness Rz is in a range of 0.1 to 50 $\mu$m.

[2] The self-adhesive sheet according to [1], in which the 4-methyl-1-pentene-based polymer includes a constitutional unit derived from 4-methyl-1-pentene and a constitutional unit derived from an $\alpha$-olefin having 2 to 20 carbon atoms other than the 4-methyl-1-pentene.

[3] The self-adhesive sheet according to [1] or [2], in which when a sum of a constitutional unit derived from 4-methyl-1-pentene and a constitutional unit derived from an $\alpha$-olefin having 2 to 20 carbon atoms other than the 4-methyl-1-pentene is 100 mol%, a content of the constitutional unit derived from the 4-methyl-1-pentene is 10 mol% or more and 90 mol% or less.

[4] The self-adhesive sheet according to any one of [1] to [3], in which at least one or more temperatures showing the local maximum value of the loss tangent (tan $\delta$) of dynamic viscoelasticity of the self-adhesive sheet are present in a range of 10°C or higher and 40°C or lower, and the local maximum value of the loss tangent is 0.8 or more and 3 or less.

[5] The self-adhesive sheet according to any one of [1] to [4], in which an average thickness of the self-adhesive sheet is in a range of 0.01 mm or more and 30 mm or less.

[6] The self-adhesive sheet according to any one of [1] to [5], in which the arithmetic average roughness Ra on one surface of the self-adhesive sheet is 3.5 um or less.

[7] The self-adhesive sheet according to any one of [1] to [6], in which the self-adhesive sheet is processed into one or two or more shapes selected from a parallel linear shape, a wavy shape, a grid shape, a mesh shape, a honeycomb shape, and a dotted shape in an in-plane direction.

[8] A fixing member including a laminated portion in which a plurality of the self-adhesive sheets according to any one of [1] to [7] are in contact with each other.

[9] A touch fastener including: the self-adhesive sheet according to any one of [1] to [8] as an attachment and detachment surface.

[10] A wiring board including:

a self-adhesive sheet, and
a wiring,

in which the sheet contains a 4-methyl-1-pentene-based polymer and satisfies the following conditions,
(Conditions)
in the self-adhesive sheet, one or more temperatures showing a local maximum value of a loss tangent (tan $\delta$), which is obtained by dynamic viscoelasticity measurement under conditions of a temperature rising rate of 4 °C/min, a frequency of 1.59 Hz, and a strain amount of 0.1%, are present in a range of 10°C or higher and 100°C or lower, and the local maximum value of the loss tangent is 0.5 or more and 3.5 or less.

[11] The wiring board according to [10], in which the wiring is electrically connected to an electrode, and the self-adhesive sheet covers the wiring and has an opening which exposes the electrode.
[12] The wiring board according to [10] or [11], which has deformability.
[13] The wiring board according to any one of [10] to [12], in which the self-adhesive sheet has insulating properties.
[14] The wiring board according to any one of [10] to [13], in which the wiring is formed of a conductive ink.
[15] The wiring board according to any one of [10] to [14], in which the wiring board has a sucker-shaped recess portion that is gently curved in a part of an outer surface of the self-adhesive sheet.
[16] The wiring board according to any one of [10] to [15], in which in the wiring board, a thickness of an outer edge portion is smaller than that of a central portion.
[17] The wiring board according to any one of [10] to [16], in which the wiring board is used so that an outer surface on a self-adhesive sheet side comes into close contact with a skin of a living body.
[18] An electronic device including:

the wiring board according to any one of [10] to [17],
an electrode which is exposed to an outer surface of the self-adhesive sheet, and
an electronic component which is electrically connected to the wiring.

[19] A sealing member including:

a self-adhesive member having a self-adhesive surface and formed of a self-adhesive sheet satisfying the following Requirement 1,
an opening and closing portion is formed by causing the self-adhesive surfaces to face each other, and
the opening and closing portion is opened when the facing self-adhesive surfaces are separated from each other, and is closed when the facing self-adhesive surfaces are caused to adhere to each other,
(Requirement 1): at least one or more temperatures showing a local maximum value of a loss tangent (tan $\delta$), which is obtained by dynamic viscoelasticity measurement under conditions of a temperature rising rate of 4 °C/min, a frequency of 1.59 Hz, and a strain amount of 0.1%, are present in a range of 10°C or higher and 100°C or lower, and the local maximum value of the loss tangent is 0.5 or more and 3.5 or less.

[20] The sealing member according to [19], in which the 4-methyl-1-pentene-based polymer includes a constitutional unit derived from 4-methyl-1-pentene and a constitutional unit derived from an $\alpha$-olefin having 2 to 20 carbon atoms other than the 4-methyl-1-pentene.
[21] The sealing member according to [19] or [20], further including:

a resin plate disposed on a side opposite to the self-adhesive surface with respect to the self-adhesive member, and
the resin plate satisfies the following Requirements 2 to 4, (Requirement 2) : the resin plate has a bending elastic modulus of 500 MPa to 2500 MPa (JIS 7171),
(Requirement 3): the resin plate has a thickness of 500 pm to 3000 um, and
(Requirement 4): the resin plate has hinge structures at both ends.

[22] The sealing member according to any one of [19] to [21], further includes a cushioning material provided between the self-adhesive member and the resin plate.
[23] The sealing member according to any one of [19] to [22], in which one or two or more selected from the group consisting of a tube, a catheter, a power cable, a communication cable, and a wire penetrate the opening and closing portion.
[24] A packaging member including:

the sealing member according to any one of [19] to [23]; and a packaging material.

ADVANTAGEOUS EFFECTS OF INVENTION

According to the first invention, it is possible to provide a self-adhesive sheet, a fixing member, and a touch fastener that have improved fixability. According to the second invention, it is possible to provide a wiring board and an electronic component that have good adhesion. According to the third invention, it is possible to provide a sealing member having excellent airtightness of an opening and closing portion in an environment close to normal temperature.

BRIEF DESCRIPTION OF THE DRAWINGS

Fig. 1 is a cross-sectional view schematically showing a wiring board of a second embodiment.
Fig. 2 is a cross-sectional view schematically showing a modified example of the wiring board of the second embodiment.
Fig. 3 is a plan view schematically showing an example of a sheet having a parallel linear gap.
Fig. 4 is a plan view schematically showing an example of a sheet having a wavy gap.
Fig. 5 is a plan view schematically showing an example of a honeycomb-shaped sheet.
Fig. 6 is a plan view schematically showing an example of a mesh-shaped sheet.
Fig. 7 is a plan view schematically showing an example of a grid-shaped sheet.
Fig. 8 is a cross-sectional view schematically showing a modified example of the wiring board of the second embodiment.
Fig. 9 is a schematic view showing an embodiment of a self-adhesive member used to surround an opening and closing portion.
Fig. 10 is a schematic view for explaining a method for producing an opening and closing portion by overlapping self-adhesive members after processing.
Fig. 11 is a schematic view showing an embodiment of the sealing member of the present disclosure attached to another material.
Fig. 12 is a schematic view showing a sealing member including a cushioning material.
Fig. 13 is a schematic view showing a sealing member including a resin plate and a cushioning material.
Fig. 14 is a schematic view showing a method for opening the opening and closing portion by separating the self-adhesive surfaces from each other.
Fig. 15 is a schematic view showing a method for causing a penetration member to penetrate the opening and closing portion.
Fig. 16 is a schematic view showing a method for closing the opening and closing portion with the penetration member interposed therebetween.
Fig. 17 is a schematic view showing a method for maintaining a close contact state of the opening and closing portion with the penetration member interposed therebetween.

DESCRIPTION OF EMBODIMENTS

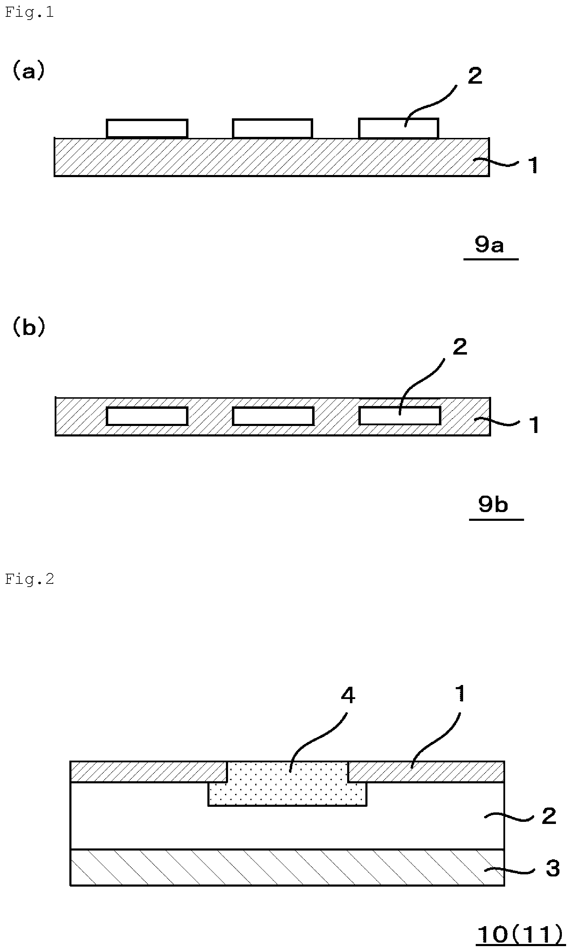

Embodiments of the present invention will be described in detail with reference to the drawings as appropriate.
In all the drawings, the same constitutional components are denoted by the same reference signs, and description thereof will not be repeated as appropriate. In order to avoid complication, (i) when a plurality of the same components are present on the same drawing, there may be a case where the reference numeral is given to only one component without giving the reference numeral to all the components; and (ii) in particular, in Fig. 2 and subsequent drawings, there may be a case where the reference numeral is not given again to the same components as those in Fig. 1.
All the drawings are merely illustrative. The shape, dimensional ratio, and the like of each of the members in the drawings do not necessarily correspond to those of an actual article.
In the present specification, unless otherwise specified, the term "substantially" means to include a range in consideration of production tolerances, assembly variations, and the like.
In the present specification, the expression "a to b" in the description of a numerical range represents a or more and b or less unless specified otherwise. For example, "1% to 5% by mass" means "1% by mass or more and 5% by mass or less".
In the present specification, the term "sheet" is a term having a concept including not only those generally called "sheet" but also those generally called "film".
It should be noted that those generally called "sheet" have a thickness of 250 um or more, and those generally called a "film" have a thickness of less than 250 um.
Further, in the present specification, the term "self-adhesive" means that in a tensile test (chuck-to-chuck distance: 50 mm, tension rate: 50 mm/min) after pressure is applied to the surfaces of sheets containing a 4-methyl-1-pentene-based polymer at 0.026 MPa for 1 second using a heat sealer (TP701B, manufactured by Tester Sangyo Co. Ltd.) set to 40°C and the sheets are left to stand for 24 hours in an environment at a temperature of 23°C and a relative humidity of 50%, the maximum shear stress (MPa) is 2.0 MPa or more.

<First Embodiment>

First, an embodiment of the first invention will be described.

1. Self-Adhesive Sheet

[Loss Tangent (tan $\delta$)]

In the self-adhesive sheet according to the present embodiment, at least one or more temperatures showing a local maximum value of a loss tangent (tan $\delta$), which is obtained by dynamic viscoelasticity measurement under the conditions of a temperature rising rate of 4 °C/min, a frequency of 1.59 Hz, and a strain amount of 0.1%, are present in a range of 10°C or higher and 100°C or lower, and the local maximum value of the loss tangent is 0.5 or more and 3.5 or less.

For example, the self-adhesive sheet can be cut into a test piece having a size of 50 mm in length $\times$ 5 mm in width, and measurement can be performed using a rheometer under the conditions of a frequency of 1.59 Hz, a temperature rising rate of 4 °C/min, a measurement temperature range of 0°C to 110°C, a strain amount of 0.1%, a chuck-to-chuck distance of 20 mm, and a tensile mode.

The present inventors have intensively studied to realize a self-adhesive sheet having excellent fixability. As a result, it has been found that in the self-adhesive sheet containing the 4-methyl-1-pentene-based polymer, by adjusting the temperature range showing the local maximum value of the loss tangent (tan $\delta$) and the local maximum value of the loss tangent to the above ranges, the performance balance between fixability, flexibility, and shape followability can be improved.

The details of the reason for this are not clear, but the reason may be considered as follows.

First, by increasing the loss tangent (tan $\delta$) in a relatively low frequency region of 1.59 Hz, the self-adhesive surface easily follows a force (also referred to as a slow force) applied over time, compared to a force such as a momentary impact. Therefore, it is presumed that the surface shapes of the self-adhesive sheets follow each other due to the force applied when the self-adhesive sheets are caused to adhere to each other or when used after the adhesion, and the fixing power against the force to pull the sheets apart (in particular, a force applied in a planar direction) is enhanced.

Further, since the self-adhesive sheet in which the local maximum value of the loss tangent is within the above range in a range of 10°C or higher and 100°C or lower can convert more of the mechanical energy given at the time of deformation into thermal energy and can absorb a large amount of energy, it is considered that the restoration speed after deformation becomes slow. As a result, it is considered that it is possible to satisfactorily follow the deformation while maintaining the flexibility of the self-adhesive sheet, and as a result, the fixability can be improved.

The loss tangent of the self-adhesive sheet according to the present embodiment can be controlled to be in the above range, for example, by appropriately adjusting (1) the kind and mixing ratio of a 4-methyl-1-pentene-based polymer (a1) described later, (2) the presence or absence of crosslinking of the sheet, (3) a method for molding the self-adhesive sheet, and the like.

Specifically, for example, the mixing ratio of the 4-methyl-1-pentene-based polymer (a1) in the self-adhesive sheet may be increased, and the sheet may not be crosslinked.

It is preferable that the self-adhesive sheet according to the present embodiment is uncrosslinked from the viewpoint of improving fixability. That is, it is preferable that the self-adhesive sheet according to the present embodiment is an uncrosslinked sheet that has not been subjected to a crosslinking treatment such as ionization radiation crosslinking using an electron beam or $\gamma$-ray, for example. With this, the local maximum value of the loss tangent in a range of 10°C or higher and 100°C or lower can be improved, and a self-adhesive sheet having more excellent fixability can be obtained.

In the self-adhesive sheet according to the present embodiment, it is preferable that at least one or more temperatures showing the local maximum value of the loss tangent (tan $\delta$) of dynamic viscoelasticity are present in a range of 10°C or higher and 80°C or lower, it is more preferable that one or more temperatures showing the local maximum value of the loss tangent are present in a range of 10°C or higher and 60°C or lower, it is even more preferable that one or more temperatures showing the local maximum value of the loss tangent are present in a range of 10°C or higher and 50°C or lower, and it is particularly preferable that one temperature showing the local maximum value of the loss tangent is present in a range of 10°C or higher and 50°C or lower. With this, when the self-adhesive sheet is in contact with the human skin at about 25°C to 40°C or when the self-adhesive sheet is arranged at a position near the human body, better fixability is obtained.

In addition, in the self-adhesive sheet according to the present embodiment, the local maximum value of the loss tangent is preferably 0.8 or more, more preferably 1.0 or more, and even more preferably 1.2 or more. In the self-adhesive sheet according to the present embodiment, the local maximum value of the loss tangent is preferably 3.0 or less, and more preferably 2.8 or less.

With this, it is possible to improve the performance balance between flexibility and shape followability while obtaining the fixability of the self-adhesive sheet according to the present embodiment. Here, the larger the local maximum value of the loss tangent, the stronger the viscous properties of the self-adhesive sheet. It is considered that since the self-adhesive sheet, which has strong viscous properties, can convert more of mechanical energy given at the time of deformation into thermal energy and absorb more energy, the restoration speed after deformation becomes more moderate. As a result, it is considered that while maintaining flexibility of the self-adhesive sheet, the shape after deformation can be more satisfactorily maintained, the deformation can be followed more satisfactorily, or the fixability to the planar direction can be improved.

[Surface Roughness]

In the self-adhesive sheet according to the present embodiment, the arithmetic average roughness Ra of one surface is in a range of 0.01 to 10 um, and the ten-point average roughness Rz is 0.1 to 50 um. With this, good fixability can be obtained. The arithmetic average roughness Ra is preferably 0.02 to 8 $\mu$m, and more preferably 0.03 to 5 um. In addition, from the viewpoint of obtaining good adhesive properties by entwining fine unevenness on the surface of the self-adhesive sheet at the use temperature of the self-adhesive sheet, the arithmetic average roughness Ra is preferably 3.5 um or less, more preferably 2.5 um or less, and even more preferably 2.0 um or less. The ten-point average roughness Rz is preferably 0.2 to 40 um, more preferably 0.3 to 25 $\mu$m, and even more preferably 0.3 to 20 um.

In the present embodiment, by controlling the arithmetic average roughness Ra and the ten-point average roughness Rz in combination, the variation in unevenness can be effectively suppressed and more uniform fixing power can be obtained on the entire surface of the self-adhesive sheet.

In addition, in the self-adhesive sheet according to the present embodiment, the arithmetic average roughness Ra and the ten-point average roughness Rz of at least the surface on the side to be the adhesive surface (fixed surface) are required to satisfy the above numerical ranges. In other words, in a touch fastener described later, the arithmetic average roughness Ra and the ten-point average roughness Rz satisfy the above numerical ranges at least on the surface side where the self-adhesive sheets face each other.

The method for adjusting the surface roughness of the self-adhesive sheet according to the present embodiment is not particularly limited, and a known method can be used. For example, the adjustment may be performed by a method by mold molding such as embossing in a sheet production process, a method for transferring the surface shape of an interleaving paper (separator) by interposing the interleaving paper between the sheets when winding up the sheet, polishing, and a blasting treatment such as water blasting and air blasting, and the like. Among these, a water blasting treatment is preferable as the blasting treatment.

The arithmetic average roughness Ra and the ten-point average roughness Rz can be measured according to JIS B0610-2001.

[Thickness]

The thickness of the self-adhesive sheet according to the present embodiment is not particularly limited, but is preferably in a range of 0.01 mm or more and 30 mm or less, more preferably in a range of 0.01 mm or more and 10 mm or less, and even more preferably in a range of 0.02 mm or more and 5 mm or less, and still even more preferably in a range of 0.03 mm or more and 2 mm or less.

By setting the thickness of the self-adhesive sheet according to the present embodiment to the above lower limit value or more, a good balance between shape followability, mechanical properties, moldability, moisture resistance, and the like can be obtained while improving fixability.

By setting the thickness of the self-adhesive sheet according to the present embodiment to the above upper limit value or less, it is possible to improve lightness, appearance, and handleability while maintaining good fixability.

The self-adhesive sheet according to the present embodiment may have a ventilation hole in order to enhance air permeability depending on the application. For example, by using processing techniques such as mechanical punching, needle processing, laser perforation, and water jet, a large number of ventilation holes communicating with each other can be provided on the front and back sides.

[Density]

The density of the self-adhesive sheet according to the present embodiment measured according to ASTM D 1505 (underwater substitution method) is preferably 0.3 to 1.5 $g/cm^3$, more preferably 0.5 to 1.2 $g/cm^3$, even more

preferably 0.8 to 0.9 g/cm$^3$, and still even more preferably 0.83 to 0.85 g/cm$^3$.

[Transparency]

When the self-adhesive sheet of the present embodiment is applied to application for utilizing transparency described later, it is desirable that the internal haze with respect to visible light (hereinafter, also simply referred to as "internal haze") is 30% or less.

Here, the "internal haze" refers to a haze excluding the haze due to the shape of the outer surface of the self-adhesive sheet. In addition, the "internal haze" is a value measured at 25°C for the self-adhesive sheet according to JIS-K 7105.

The internal haze of the self-adhesive sheet of the present embodiment is preferably 30% or less, more preferably 20% or less, even more preferably 13% or less, still even more preferably 5% or less, yet still even more preferably 2.0% or less, and particularly preferably 1.0% or less.

On the other hand, the lower the internal haze of the self-adhesive sheet of the present embodiment is, the better it is, from the viewpoint of transparency, but from the viewpoint of balance with adhesiveness and the like, the lower limit value thereof is preferably 0.01% or more.

That is, the transparency of the self-adhesive sheet of the present embodiment can be evaluated by the internal haze.

In addition, the transparency of the self-adhesive sheet of the present embodiment may be evaluated not only by the above-mentioned internal haze but also by the internal light transmittance.

Here, the "internal light transmittance" refers to a light transmittance excluding the influence of the shape of the outer surface of the self-adhesive sheet.

The internal light transmittance of the self-adhesive sheet of the present embodiment is preferably 90.0% or more, more preferably 95.0% or more, even more preferably 97.0% or more, still even more preferably 98.0% or more, yet still even more preferably 99.0% or more, and ideally 100%.

Specifically, the internal haze and the internal light transmittance of the self-adhesive sheet of the present embodiment can be measured as follows.

-Internal Haze-

The internal haze of the self-adhesive sheet of the present embodiment (hereinafter, also referred to as internal haze (H1)) is obtained by the following method.

First, a haze (H2) (%) was measured by sandwiching only silicone oil (SHIN-ETSU SILICONE (trademark), model number: KF96-100CS, manufactured by Shin-Etsu Chemical Co., Ltd.) between two glass plates in advance. Next, the haze (H3) (%) is measured by sandwiching the self-adhesive sheet whose surface is uniformly coated with silicone oil between the two glass plates.

Next, the internal haze (H1) (%) of the self-adhesive sheet is obtained by taking a difference between the obtained values as in the following expression (1).

$$\text{Internal haze (H1)} = \text{haze (H3)} - \text{haze (H2)} \quad (1)$$

It should be noted that the haze (H2) and the haze (H3) (both have a unit of %) are measured using the following apparatus under the following measurement conditions.

Measuring apparatus: HAZE METER TC-HIIIDPK manufactured by Tokyo Denshoku Co., Ltd.

Sample size: 30 mm in width × 30 mm in length
Measurement conditions: compliant with JIS-K 7136 (2000)
Measurement temperature: room temperature (25°C)

-Internal Light Transmittance-

During the measurement of the internal haze of the self-adhesive sheet of the present embodiment, a light transmittance (T2) (%) is measured instead of the haze (H2) in the measurement of the haze (H2), and a light transmittance (T3) (%) is measured instead of the haze (H3) in the measurement of the haze (H3). Next, an internal light transmittance (T1) (%) of the self-adhesive sheet is obtained by the following expression (2).

$$\text{Internal light transmittance (T1)} = 100 - (\text{light transmittance}$$

$$\text{(T2)} - \text{light transmittance (T3))} \quad (2)$$

Hereinafter, each component constituting the self-adhesive sheet according to the present embodiment will be described.

[4-Methyl-1-Pentene-Based Polymer]

The self-adhesive sheet according to the present embodiment contains a 4-methyl-1-pentene-based polymer (a1). With this, the local maximum value of the loss tangent (tan $\delta$) can be made larger.

Examples of the 4-methyl-1-pentene-based polymer (a1) according to the present embodiment include a 4-methyl-1-pentene·$\alpha$-olefin copolymer (c) including a constitutional unit (c1) derived from 4-methyl-1-pentene and a constitutional unit (c2) derived from an $\alpha$-olefin having 2 to 20 carbon atoms other than 4-methyl-1-pentene.

Here, in the present embodiment, the "$\alpha$-olefin having 2 to 20 carbon atoms" means not including 4-methyl-1-pentene unless otherwise specified.

In the 4-methyl-1-pentene·$\alpha$-olefin copolymer (c) according to the present embodiment, from the viewpoint of further improving flexibility and fixability of the self-adhesive sheet, when a sum of the constitutional unit (c1) and the constitutional unit (c2) is 100 mol%, it is preferable that a content of the constitutional unit (c1) is 10 mol% or more and 90 mol% or less, and a content of the constitutional unit (c2) is 10 mol% or more and 90 mol% or less.

In addition, in the 4-methyl-1-pentene·$\alpha$-olefin copolymer (c) according to the present embodiment, from the viewpoint of further improving flexibility, mechanical properties, or the like of the self-adhesive sheet, when the sum of the constitutional unit (c1) and the constitutional unit (c2) is 100 mol%, it is more preferable that the content of the constitutional unit (c1) is 30 mol% or more and 90 mol% or less, and the content of the constitutional unit (c2) is 10 mol% or more and 70 mol% or less, it is even more preferable that the content of the constitutional unit (c1) is 50 mol% or more and 90 mol% or less, and the content of the constitutional unit (c2) is 10 mol% or more and 50 mol% or less, it is still even more preferable that the content of the constitutional unit (c1) is 60 mol% or more and 90 mol% or less and the content of the constitutional unit (c2) is 10 mol% or more and 40 mol% or less, and it is particularly preferable that the content of the constitutional unit (c1) is 65 mol% or more and 90 mol% or less and the content of the constitutional unit (c2) is 10 mol% or more and 35 mol% or less.

In the present embodiment, examples of the $\alpha$-olefin having 2 to 20 carbon atoms used in the 4-methyl-1-pentene ·$\alpha$-olefin copolymer (c) includes a linear or branched $\alpha$-olefin, a cyclic olefin, an aromatic vinyl compound, a conjugated diene, a functionalized vinyl compound, and the like, and the linear $\alpha$-olefin is preferable.

The number of carbon atoms of the linear $\alpha$-olefin is preferably 2 to 10, more preferably 2 to 5, and even more preferably 2 to 3. Examples of the linear $\alpha$-olefin include ethylene, propylene, 1-butene, 1-pentene, and the like. One kind or two or more kinds selected from ethylene, propylene, 1-butene, 1-pentene, 1-hexene, 1-octene, and 1-decene are preferable, and at least one kind selected from ethylene and propylene is more preferable.

The number of carbon atoms of the branched $\alpha$-olefin is preferably 5 to 20, and more preferably 5 to 15. Examples of the branched $\alpha$-olefin include 3-methyl-1-butene, 3-methyl-1-pentene, 3-ethyl-1-pentene, and the like.

The number of carbon atoms of the cyclic olefin is preferably 5 to 15. Examples of the cyclic olefin include cyclopentene, cyclohexene, cycloheptene, norbornene, 5-methyl-2-norbornene, tetracyclododecene, vinylcyclohexane, and the like.

Examples of the aromatic vinyl compound include mono- or poly-alkylstyrenes such as styrene, $\alpha$-methylstyrene, o-methylstyrene, m-methylstyrene, p-methylstyrene, o,p-dimethylstyrene, o-ethylstyrene, m-ethylstyrene, p-ethylstyrene, and the like.

The number of carbon atoms of the conjugated diene is preferably 4 to 20, and more preferably 4 to 10. Examples of the conjugated diene include 1,3-butadiene, isoprene, chloroprene, 1,3-pentadiene, 2,3-dimethylbutadiene, 4-methyl-1,3-pentadiene, 1,3-hexadiene, 1,3-octadiene, and the like.

Examples of the functionalized vinyl compound include unsaturated carboxylic acids such as a hydroxyl group-containing olefin, a halogenated olefin, a (meth) acrylic acid, a propionic acid, a 3-butenoic acid, a 4-pentenoic acid, a 5-hexenoic acid, a 6-heptenoic acid, a 7-octenoic acid, an 8-nonenoic acid, a 9-decenoic acid, and a 10-undecenoic acid, and acid anhydrides or acid halides thereof, unsaturated amines such as allylamine, 5-hexenamine, 6-hepteneamine, and the like, (2,7-octadienyl) succinic anhydride, pentapropenyl succinic anhydride, an unsaturated epoxy compound, an ethylenically unsaturated silane compound, and the like.

Examples of the hydroxyl group-containing olefin include a linear or branched terminal hydroxylated $\alpha$-olefin having 2 to 20 carbon atoms, and preferably 2 to 15 carbon atoms, and the like.

Examples of the halogenated olefin include a linear or branched halogenated $\alpha$-olefin having 2 to 20 carbon atoms, and preferably 2 to 15 carbon atoms, and the like.

These α-olefins having 2 to 20 carbon atoms can be used alone or in combination of two or more kinds thereof. Among these, an α-olefin having 2 to 5 carbon atoms is preferable, and ethylene and propylene are more suitable. However, the use of propylene is particularly preferable from a viewpoint of further improving flexibility and the like.

It should be noted that the 4-methyl-1-pentene·α-olefin copolymer (c) may contain constitutional units other than the constitutional unit (c1) and the constitutional unit (c2) within a range of not impairing the object of the present invention. Other constitutions include constitutional units derived from non-conjugated polyene.

Examples of the non-conjugated polyene include a linear, branched, or cyclic diene having preferably 5 to 20 carbon atoms, and more preferably 5 to 10 carbon atoms, various norbornenes, norbornadienes, and the like. Among these, 5-vinylidene-2-norbornene and 5-ethylidene-2-norbornene are preferable.

From a viewpoint of further improving flexibility or mechanical strength of the self-adhesive sheet, the intrinsic viscosity [η] in decalin of 135°C of the 4-methyl-1-pentene-based polymer according to the present embodiment is preferably 0.01 to 5.0 dL/g, more preferably 0.1 to 4.0 dL/g, even more preferably 0.5 to 3.0 dL/g, and particularly preferably 1.0 to 2.8 dL/g.

The density of the 4-methyl-1-pentene-based polymer according to the present embodiment, measured by ASTM D 1505 (underwater substitution method), is preferably 0.810 to 0.850 $g/cm^3$, more preferably 0.820 to 0.850 $g/cm^3$, and even more preferably 0.830 to 0.850 $g/cm^3$.

The 4-methyl-1-pentene-based polymer according to the present embodiment can be produced by various methods. For example, it is possible to produce the 4-methyl-1-pentene-based polymer according to the present embodiment by using known catalysts such as magnesium-supported titanium catalysts; metallocene catalysts described in International Publication No. WO 01/53369, International Publication No. WO 01/027124, Japanese Unexamined Patent Publication No. H03-193796, Japanese Unexamined Patent Publication No. H02-41303, and the like; olefin polymerization catalysts containing a metallocene compound described in International Publication No. WO 2011/055803, and the like.

Although the content of the 4-methyl-1-pentene-based polymer (a1) in the self-adhesive sheet according to the present embodiment is not particularly limited, when the entire content of the self-adhesive sheet is 100% by mass, the content of the 4-methyl-1-pentene-based polymer (a1) is preferably 50% by mass or more, more preferably 60% by mass or more, even more preferably 65% or more by mass, still even more preferably 70% by mass or more, and particularly preferably 75% by mass or more, and preferably 100% by mass or less, more preferably 99.5% by mass or less, even more preferably 99% by mass or less, still even more preferably 98% by mass or less, and particularly preferably 97% by mass or less.

With this, it is possible to obtain a self-adhesive sheet which has excellent balance between impact absorption properties, flexibility, shape followability, lightness, mechanical properties, handleability, appearance, moldability, moisture resistance, and the like.

The self-adhesive sheet according to the present embodiment may contain components other than the above-mentioned 4-methyl-1-pentene-based polymer (a1).

[Modified Resin (a2)]

From a viewpoint of further improving appearance, texture, and fixability, the self-adhesive sheet according to the present embodiment may contain a modified resin (a2) (here, the 4-methyl-1-pentene-based polymer (a1) according to the present embodiment is excluded). Examples of the modified resin (a2) according to the present embodiment include one kind or two or more kinds selected from a thermoplastic resin, a thermoplastic elastomer, and a rubber.

Examples of the thermoplastic resin (here, the 4-methyl-1-pentene-based polymer (a1) according to the present embodiment is excluded) include thermoplastic polyolefin resins such as low-density polyethylene, medium-density polyethylene, high-density polyethylene, high-pressure low-density polyethylene, polypropylene, poly 1-butene, poly 4-methyl-1-pentene, poly 3-methyl-1-butene, ethylene·α-olefin copolymer, propylene·α-olefin copolymer, 1-butene·α-olefin copolymer, cyclic olefin copolymer, and chlorinated polyolefin; thermoplastic polyamide-based resins such as aliphatic polyamide (nylon 6, nylon 11, nylon 12, nylon 66, nylon 610, nylon 612) and polyether block amide copolymer; thermoplastic polyester-based resins such as polyethylene terephthalate and polybutylene terephthalate; thermoplastic vinyl aromatic resins such as polystyrene, ABS resin, and AS resin; vinyl chloride resins; vinylidene chloride resins; acrylic resins; ethylene-vinyl acetate copolymers; ethylene-methacrylic acid acrylate copolymers; ionomers; ethylene-vinyl alcohol copolymers; polyvinyl alcohols; fluorine-based resins such as polyvinyl fluoride resin, polytetrafluoroethylene, polyvinylidene fluoride, and ETFE; polycarbonate; polyacetal; polyphenylene oxide; polyphenylene sulfide; polyimide; polyarylate; polysulfone; polyether sulfone; rosin-based resins; terpene-based resins; petroleum resins; and the like.

Examples of the rubber include ethylene·α-olefin·diene copolymer rubber, propylene·α-olefin·diene copolymer rubber, and the like.

In addition, examples of the thermoplastic elastomer include an olefin-based elastomer, a styrene-based elastomer, an acid-modified styrene-based elastomer, a vinyl chloride-based elastomer, a urethane-based elastomer, an ester-based elastomer, an amide-based elastomer, and the like.

In addition, these modified resins (a2) optionally be modified by acid with acrylic acid, methacrylic acid, maleic acid, or the like.

These modified resins (a2) may be used alone or in combination of two or more kinds thereof.

Among these modified resins (a2), one kind or two or more kinds selected from low-density polyethylene, medium-density polyethylene, high-density polyethylene, high-pressure low-density polyethylene, polypropylene, poly 1-butene, poly 4-methyl-1-pentene, poly 3-methyl-1-butene, ethylene·$\alpha$-olefin copolymer, propylene·$\alpha$-olefin copolymer, and 1-butene·$\alpha$-olefin copolymer are preferable, and one kind or two or more kinds selected from polyethylene, polypropylene, poly-1-butene, poly-4-methyl-1-pentene, ethylene·$\alpha$-olefin copolymer, propylene·$\alpha$-olefin copolymer, 1-butene·$\alpha$-olefin copolymer, ethylene·vinyl acetate copolymer, polyether block amide, ionomer, fluorine-based resin, acid-modified fluorine-based resin, rosin-based resin, terpene-based resin, petroleum resin, and styrene-based elastomer, the addition of which improve melt tension are more preferable.

In addition, those having appropriate compatibility with the 4-methyl-1-pentene-based polymer (a1) according to the present embodiment are even more preferable. Further, among styrene-based elastomers, vinyl SIS (product name: HYBRAR, brand: 5127) and vinyl SEPS (product name: HYBRAR, brand: 7125) manufactured by Kuraray Co., Ltd., and SEBS (product name: S.O.E, brand: S1605, S1611, and L609) manufactured by Asahi Kasei Corporation can be preferably used, from a viewpoint of compatibility, a temperature range showing the local maximum value of the loss tangent, and a magnitude of the local maximum value of the loss tangent.

For the self-adhesive sheet according to the present embodiment, one kind selected from these modified resins (a2) can be used alone or two or more kinds thereof can be used in combination.

The content of the modified resin (a2) in the self-adhesive sheet according to the present embodiment is not particularly limited, but when the entire content of the self-adhesive sheet is 100% by mass, the content of the modified resin (a2) is preferably 0.5% by mass or more, more preferably 1% by mass or more, even more preferably 2% by mass or more, still even more preferably 3% by mass or more, and preferably 50% by mass or less, more preferably 40% by mass or less, even more preferably 35% by mass or less, still even more preferably 30% by mass or less, and particularly preferably 25% by mass or less.

When the content of the modified resin (a2) is the lower limit value or more, it is possible to further improve appearance, texture, fixability, and the like of the self-adhesive sheet according to the present embodiment. When the content of the modified resin (a2) is the upper limit value or less, it is possible to further improve performance balance between the fixability and flexibility of the self-adhesive sheet according to the present embodiment.

[Other Components]

The self-adhesive sheet according to the present embodiment may be mixed with additives such as a heat stabilizer, an antioxidant, an ultraviolet absorber, a pigment, an antistatic agent, a copper inhibitor, a flame retardant, a neutralizing agent, a plasticizer, a nucleating agent, a weather stabilizer, a light stabilizer, an anti-aging agent, a fatty acid metal salt, a softener, a dispersant, a coloring agent, a lubricant, a natural oil, a synthetic oil, a wax, and the like, depending on the necessity. Among these, in particular, the plasticizer, the softener, the natural oil, and the synthetic oil may be used by controlling the kind and the addition amount in order to adjust a temperature showing a local maximum value of the loss tangent (tan $\delta$) of solid viscoelasticity and the local maximum value of the loss tangent of the self-adhesive sheet according to the present embodiment.

The resin composition containing the 4-methyl-1-pentene-based polymer (a1) can be prepared by mixing or melting and kneading each component by a dry blend, a tumbler mixer, a Banbury mixer, a single screw extruder, a twin screw extruder, a high-speed twin screw extruder, a hot roll, and the like.

In addition, the self-adhesive sheet according to the present embodiment may be formed of a single layer or a multilayer. In a case of a multilayer, at least one layer is required to be a layer containing the 4-methyl-1-pentene-based polymer (a1), and two or more layers may contain the 4-methyl-1-pentene-based polymer (a1).

<Method for Producing Self-Adhesive Sheet>

The self-adhesive sheet according to the present embodiment can be obtained, for example, by molding a resin composition containing a 4-methyl-1-pentene-based polymer (a1) or the 4-methyl-1-pentene-based polymer (a1) into a sheet shape.

The molding apparatus and the molding conditions are not particularly limited, and a conventionally known molding apparatus and molding conditions can be employed. For example, known methods such as extrusion molding, inflation molding, and calendaring molding, or the like can be applied. Among these, it is preferable to perform molding by an extrusion molding apparatus. In addition, even in a case where the self-adhesive sheet has a multilayer structure, known methods such as coextrusion (extrusion using a multi-die) and various lamination methods can be appropriately applied.

2. Fixing Member

A fixing member according to the present embodiment includes a laminated portion in which a plurality of the self-adhesive sheets are laminated to be in direct contact with each other so that the self-adhesive sheets face each other. Since the self-adhesive sheet has excellent fixability in the planar direction, the adhesion between the layers is good, and the delamination of the laminated portion is highly suppressed.

The laminated portion may be a portion in which two layers of self-adhesive sheets are laminated, or a portion in which three or more layers of self-adhesive sheets are laminated, or a long self-adhesive sheet can be folded and stacked.

In addition, the self-adhesive sheet may be used as a composite in which another member different from the self-adhesive sheet is laminated in the laminated portion.

For example, the self-adhesive sheet has excellent performance balance between fixability, flexibility, and shape followability, and therefore has excellent adhesive properties with respect to the other member. For this reason, the composite according to the present embodiment can maintain the adhesive properties between the self-adhesive sheet and the other member even when the self-adhesive sheet is used for a long time, and has excellent durability. That is, the composite according to the present embodiment has excellent performance balance between flexibility, shape memory properties, stress relaxation properties, and durability.

As a method for forming the composite according to the present embodiment, various known methods are applicable.

For example, it is possible to prepare the composite by laminating the other member on the self-adhesive sheet and, depending on the necessity, heating and pressing with a press and the like, or performing welding.

In addition, it is also possible to prepare the composite by applying an adhesive between the self-adhesive sheet and the other member, and subsequently joining the self-adhesive sheet and the other member via an adhesive.

As the adhesive, it is possible to appropriately use an SBR-based solvent adhesive or a hot melt adhesive formed of EVA, a petroleum resin, a mixture of EVA and a petroleum resin, and the like.

The other member is not particularly limited, and examples thereof include a woven fabric, a non-woven fabric, a synthetic fiber, an artificial leather, a synthetic leather, a natural leather, fur, metal, a carbon material, a rubber, a thermoplastic elastomer, a thermoplastic resin, a thermosetting resin, a polymer foam, a mesh structure (warp knitted fiber, Double Russell Mesh, 3D spring structure, and the like), a fiber reinforced plastic, a paper, wood, glass, stone, ceramic, and the like. These members may be used alone or in combination of two or more kinds thereof.

3. Touch fastener

A touch fastener according to the present embodiment includes the self-adhesive sheet as an attachment and detachment surface. Since the self-adhesive sheet has excellent fixability in the planar direction, good adhesiveness can be obtained by using the self-adhesive sheet as an attachment and detachment surface of the touch fastener, and the self-adhesive sheet can be repeatedly attached and detached.

In addition, since the touch fastener according to the present embodiment is free from the damages of loops caused by repeated attachment and detachment unlike the conventional touch fastener having loops, the deterioration of adhesiveness can be relatively reduced.

Further, since the touch fastener according to the present embodiment is less likely to make a noise when removed, it is expected to be applied in a wider range of fields than the conventional touch fastener.

[Application]

Similar to the conventional touch fastener, the touch fastener according to the present embodiment can be widely applied to application for repeated attachment and detachment. For example, the touch fastener according to the present embodiment can be used in various industries such as clothing, medical and nursing care supplies, housing equipment, automobiles and aircraft, and the like.

More specifically, from the viewpoint that the self-adhesive sheet easily fits the shape of the body and easily obtains adhesiveness, the touch fastener is used as a fixing member for clothing, for example, for innerwear, sportswear, outdoor clothing, and the like. In addition, the touch fastener can be used for sneakers, pumps, sandals, and the like as a fixing member for shoes . Further, the touch fastener can be used for a wristwatch, a spectacle, hat, and the like as a fixing member for fashion accessories. Further, the touch fastener can be used as a medical fixing member, for example, for a fixing tape, a band, a belt, a supporter, or the like. From the same point of view, the touch fastener can be used as materials for wearables, for example, for base materials and members for biosensing devices, e-sports devices, techno-sports devices, virtual reality (VR) and augmented reality (AR), smart watches, smart glasses, robot suits, and the like.

In addition, since the self-adhesive sheet can obtain more flexibility and followability at a temperature close to the body temperature, it is possible to easily prepare daily necessities such as bags, cups, and boxes extemporarily from the viewpoint of easy adhesion at the body temperature. By taking advantage of this ease, the touch fastener can be used, for example, for outdoor goods, sports-related goods, base materials and members in the event of a disaster or emergency. From the same point of view, the touch fastener can be used as a new material for arts, fine arts, work, and the like, such as DIY material, art work material, origami substitute material.

Further, since the self-adhesive sheet exhibits a high affinity with the human body, the touch fastener can be suitably used for apparel materials, sheet materials, bedding materials, grips, eyeglasses, helmets, wigs, headphones, earphones, watches, belts, and the like.

In addition, the touch fastener can be used in a wide range of applications such as toys, stationery products, cable ties, wraps, and daily necessities such as sealing materials.

In addition, when the self-adhesive sheet according to the present embodiment has high transparency, the range of application is further expanded. For example, when the touch fastener is used for wristwatch bands, inner fasteners and hooks for dresses, brassieres, and the like, a new design and designability that make use of transparency can be given, and the possibilities of various products can be expanded. The transparency of the self-adhesive sheet according to the present embodiment in this case is as described above.

<Second Embodiment>

Next, an embodiment of a second invention will be described. It should be noted that the same configurations and effects as those of the first embodiment will not be repeated as appropriate.

<<Wiring Board>>

As shown in Fig. 1, a wiring board 9 of the present embodiment includes a self-adhesive sheet 1 and a wiring 2. The self-adhesive sheet 1 contains a 4-methyl-1-pentene-based polymer and satisfies the following condition.

(Conditions)

In the self-adhesive sheet 1, one or more temperatures showing a local maximum value of a loss tangent (tan $\delta$), which is obtained by dynamic viscoelasticity measurement under conditions of a temperature rising rate of 4 °C/min, a frequency of 1.59 Hz, and a strain amount of 0.1%, are present in a range of 10°C or higher and 100°C or lower, and the local maximum value of the loss tangent is 0.5 or more and 3.5 or less.

It should be noted that Fig. 1(a) shows a wiring board 9a in which a plurality of wirings 2 are arranged on the self-adhesive sheet 1, and Fig. 1 (b) shows a wiring board 9b in which a plurality of wirings 2 are embedded inside the self-adhesive sheet 1. The number and arrangement method of the wiring 2 are not particularly limited, and a known technique can be adopted. For example, a part of the wiring may be arranged so as to be flush with a part of the surface of the sheet, or the sheet may have a recess and may be arranged so that at least a part of the wiring is exposed in the recess.

In addition, in the present embodiment, the wiring 2 is required to be a member having conductivity, and includes a so-called conductive layer and an electrode 4 described later. It should be noted that the details of the self-adhesive sheet 1, the wiring 2, and the electrode 4 will be described later.

By using the self-adhesive sheet 1 satisfying the above condition, the wiring board 9 of the present embodiment can obtain good adhesion to a living body and is effectively applied as a wearable device. That is, by controlling the predetermined loss tangent of the 4-methyl-1-pentene-based polymer contained in the self-adhesive sheet 1 as an index, good viscosity is obtained at the environmental temperature at which the electronic device using the wiring board 9 is used. As a result, it is possible to follow the living body well and exhibit excellent adhesion.

In the present embodiment, the adhesion to the living body means adhesion obtained by attaching or fixing the self-adhesive sheet 1 to the shape of the outer surface and movement of the living body due to flexibility and shape followability by the self-adhesive sheet 1.

[Loss Tangent (tan $\delta$)]

In the self-adhesive sheet 1 according to the present embodiment, at least one or more temperatures showing a local maximum value of a loss tangent (tan $\delta$), which is obtained by dynamic viscoelasticity measurement under the conditions of a temperature rising rate of 4 °C/min, a frequency of 1.59 Hz, and a strain amount of 0.1%, are present in a range of 10°C or higher and 100°C or lower, and the local maximum value of the loss tangent is 0.5 or more and 3.5 or less.

For example, the self-adhesive sheet 1 can be cut into a test piece having a size of 50 mm in length $\times$ 5 mm in width, and measurement can be performed using a rheometer under the conditions of a frequency of 1.59 Hz, a temperature rising rate of 4 °C/min, a measurement temperature range of 0°C to 110°C, a strain amount of 0.1%, a chuck-to-chuck distance of 20 mm, and a tensile mode.

The present inventors have intensively studied to realize a self-adhesive sheet 1 having excellent adhesion and fixability. As a result, it has been found that in the self-adhesive sheet 1 containing the 4-methyl-1-pentene-based polymer, by adjusting the temperature range showing the local maximum value of the loss tangent (tan $\delta$) and the local maximum value of the loss tangent to the above ranges, the performance balance between adhesion, fixability, flexibility, and shape followability with respect to the living body can be improved.

The details of the reason for this are not clear, but the reason may be considered as follows.

First, by increasing the loss tangent (tan $\delta$) in a relatively low frequency region of 1.59 Hz, the self-adhesive surface easily follows a force (also referred to as a slow force) applied over time, compared to a force such as a momentary impact. Therefore, it is presumed that good followability with respect to the surface shape or movement of the living body is obtained and adhesion and fixing power are increased.

Further, since the self-adhesive sheet 1 in which the local maximum value of the loss tangent is within the above range in a range of 10°C or higher and 100°C or lower can convert more of the mechanical energy given at the time of deformation into thermal energy and can absorb a large amount of energy, it is considered that the restoration speed after deformation becomes slow. As a result, it is considered that it is possible to satisfactorily follow the deformation while maintaining the flexibility of the self-adhesive sheet 1, and as a result, the fixability can be improved.

The loss tangent of the self-adhesive sheet 1 according to the present embodiment can be controlled to be in the above range, for example, by appropriately adjusting (1) the kind and mixing ratio of a 4-methyl-1-pentene-based polymer (a1) described later, (2) the presence or absence of crosslinking of the sheet, (3) a method for molding the self-adhesive sheet 1, and the like.

Specifically, for example, the mixing ratio of the 4-methyl-1-pentene-based polymer (a1) in the self-adhesive sheet may be increased, and the sheet may not be crosslinked.

It is preferable that the self-adhesive sheet 1 according to the present embodiment is uncrosslinked from the viewpoint of improving fixability and adhesion. That is, it is preferable that the self-adhesive sheet 1 according to the present embodiment is an uncrosslinked sheet that has not been subjected to a crosslinking treatment such as ionization radiation crosslinking using an electron beam or $\gamma$-ray, for example. With this, the local maximum value of the loss tangent in a range of 10°C or higher and 100°C or lower can be improved, and a self-adhesive sheet 1 having more excellent fixability can be obtained.

In the self-adhesive sheet 1 according to the present embodiment, it is preferable that at least one or more temperatures showing the local maximum value of the loss tangent (tan $\delta$) of dynamic viscoelasticity are present in a range of 10°C or higher and 80°C or lower, it is more preferable that one or more temperatures showing the local maximum value of the loss tangent are present in a range of 10°C or higher and 60°C or lower, it is even more preferable that one or more temperatures showing the local maximum value of the loss tangent are present in a range of 10°C or higher and 50°C or lower, and it is particularly preferable that one temperature showing the local maximum value of the loss tangent is present in a range of 10°C or higher and 50°C or lower. With this, when the self-adhesive sheet 1 is in contact with the human skin at about 25°C to 40°C, or when the self-adhesive sheet 1 is arranged at a position close to the human body, better fixability, adhesion, and shape followability can be obtained.

In addition, in the self-adhesive sheet 1 according to the present embodiment, the local maximum value of the loss tangent is preferably 0.8 or more, more preferably 1.0 or more, and even more preferably 1.2 or more. In the self-adhesive sheet 1 according to the present embodiment, the local maximum value of the loss tangent is preferably 3.0 or less, and more preferably 2.8 or less.

As a result, it is possible to improve the performance balance between flexibility and shape followability while obtaining the fixability and adhesion of the self-adhesive sheet 1 according to the present embodiment. Here, the larger the local maximum value of the loss tangent, the stronger the viscous properties of the self-adhesive sheet 1. It is considered that since the self-adhesive sheet 1, which has strong viscous properties, can convert more of mechanical energy given at a time of deformation into thermal energy and absorb more energy, the restoration speed after deformation becomes more moderate. As a result, it is considered that while maintaining flexibility of the self-adhesive sheet 1, the shape after deformation can be more satisfactorily maintained, the deformation can be followed more satisfactorily, or the fixability and adhesion with respect to the skin or movement of the living body can be improved.

By further providing the following configuration to the wiring board 9 of the present embodiment, better adhesion can be obtained, and further, characteristics and effects can be obtained. Hereinafter, description will be made with reference to Figs. 2 to 8.

As shown in Fig. 2, a wiring board 10 of the present embodiment includes the wiring 2 electrically connected to the electrode 4, and the self-adhesive sheet 1 that covers the wiring 2 and has an opening for exposing the electrode 4. That is, the wiring board 10 is an example in which the base material 3, the wiring 2, and the self-adhesive sheet 1 are laminated in this order, and the electrode 4 is exposed on a part of the outer surface of the self-adhesive sheet 1.

In addition, an electronic device 11 of the present embodiment includes the wiring board 10, the electrode 4 exposed in the opening of the self-adhesive sheet 1, and an electronic component electrically connected to the wiring 2. It should be noted that an electronic component is not shown in Fig. 2.

<Self-Adhesive Sheet 1>

The self-adhesive sheet 1 of the present embodiment has flexibility and shape followability, and functions to brining the wiring board 10 into close contact with the living body.

In the present embodiment, the self-adhesive sheet 1 covers the wiring 2 and has an opening that exposes the electrode 4. In addition, it is preferable that the self-adhesive sheet 1 is covered so as to suppress electric leakage and discharge from the wiring 2.

It should be noted that the covering is not limited to a case of being continuous, and the covering may be partially discontinuous .

In addition, the number, arrangement, size, and the like of the opening of the self-adhesive sheet 1 are set according to the number, arrangement, size, and the like of the electrode 4 used. From the viewpoint of suppressing electric leakage and discharge, at least a part of the electrode 4 is required to be exposed in the opening, and the opening area is preferably the same as or smaller than the cross-sectional area of the electrode 4.

[Insulating Properties]

It is preferable that the self-adhesive sheet 1 has insulating properties at least on the outer surface side. With this, the self-adhesive sheet 1 of the wiring board 10 can be safely used by being directly attached to the skin of a living body and preventing electrical stimulation when energized.

[Air Permeability]

The self-adhesive sheet 1 may have at least a part with air permeability depending on the application. With this, it is possible to improve the texture of the electronic device 11 using the wiring board 10 and reduce the occurrence of stuffiness. In addition, the weight can be reduced and the feeling of wearing can be improved.

In the present embodiment, the air permeability is measured under the conditions of 24°C and 50% RH according to JIS K 6400-7:2012 (method B), and the ventilation amount is preferably 1 $cc/cm^2/sec$ or more, more preferably 5 $cc/cm^2/sec$ or more, even more preferably 10 $cc/cm^2/sec$ or more, still even more preferably 20 $cc/cm^2/sec$ or more, and particularly preferably 30 $cc/cm^2/sec$ or more. On the other hand, the upper limit of the ventilation amount is not particularly limited, and is, for example, 10,000 $cc/cm^2/sec$ or less.

The air permeability of the self-adhesive sheet 1 can be obtained by, for example, (1) forming the self-adhesive sheet 1 using a foam, (2) forming a through hole in the self-adhesive sheet 1, or (3) deforming the shape of the self-adhesive sheet 1, and the above (1) to (3) may be combined. Each case will be described below.

In a case of (1) forming the self-adhesive sheet 1 using a foam, for example, open cells included in the foam may be connected from one surface to the other surface of the self-adhesive sheet 1 to obtain air permeability. The self-adhesive sheet 1 may have closed cells in addition to open cells. The details of the foam will be described later.

The through hole of the above (2) can be obtained by a known drilling processing for the molded self-adhesive sheet 1. As the drilling processing, for example, mechanical punching, needle processing, laser perforation, water jet, and the like can be used. The hole diameter of the through hole is not particularly limited, and is, for example, 0.1 mm or more and 50 mm or less. In addition, the through holes may be uniformly formed on the entire surface of the self-adhesive sheet 1, and may be formed only in a portion where air permeability is desired, or may be formed at a high density in the portion where air permeability is desired.

For the shape deformation processing of the above (3), a gap may be processed to have a shape such as parallel linear shape, a wavy shape, a grid shape, a mesh shape (net shape), a honeycomb shape, or a dotted shape in the in-plane direction (in the xy plane) of the self-adhesive sheet 1. These shapes may be a combination of one or two or more shapes . In addition, the gap may be processed in at least a part of the self-adhesive sheet 1.

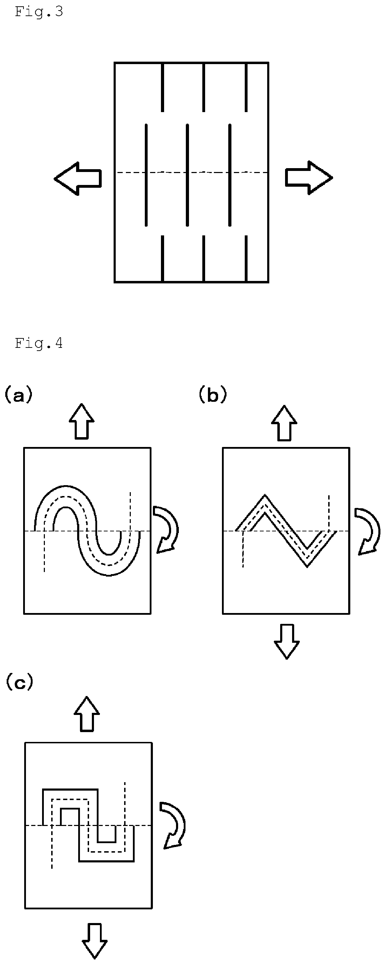

For example, the parallel linear shapes do not have to be all the same length, and the linear line extending from one outer edge toward the central portion of the self-adhesive sheet 1 and the linear line extending at the central portion may be parallel with each other. Fig. 3 is a plan view showing an example of the self-adhesive sheet having a parallel linear gap. With this, the self-adhesive sheet 1 can be stretched in a direction orthogonal to the parallel lines.

Further, the wavy shape is not limited to a curved line, and a triangular or rectangular uneven shape may be periodically repeated like a wave. Fig. 4(a) shows an example of a self-adhesive sheet 1 having a curved wavy gap, and Fig. 4(b) shows an example of a self-adhesive sheet 1 having a triangular wavy gap, Fig. 4(c) shows an example of the self-adhesive sheet 1 having a rectangular wavy gap. With this, the self-adhesive sheet 1 can be stretched in the uneven direction of the wave (vertical direction in Fig. 3). It should be noted that Fig. 4 shows an example in which two wavy slits for one cycle are formed in parallel, but the wave cycle and the number of slits are not limited thereto.

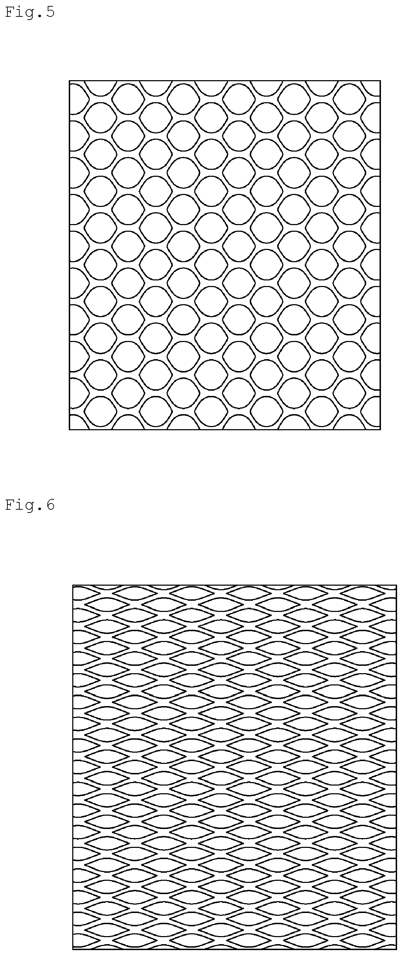

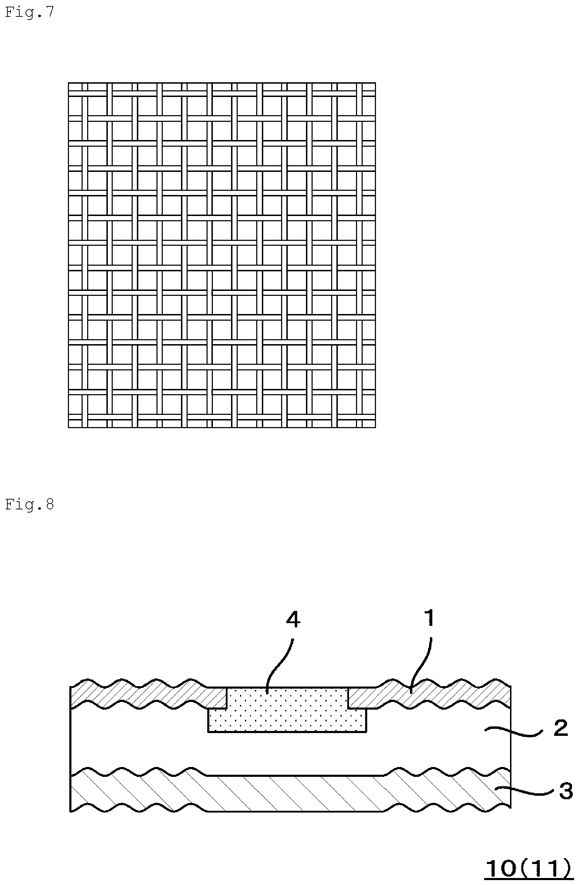

In addition, Fig. 5 shows an example of a honeycomb-shaped self-adhesive sheet 1 in a plan view, Fig. 6 shows an example of a mesh-shaped self-adhesive sheet 1 in a plan view, and Fig. 7 shows a grid-shaped self-adhesive sheet 1 in a plan view.

The gap may be either a slit-shaped fine line or a hole-shaped opening. The size of the gap is appropriately set according to the application and the processing shape from the viewpoint of obtaining good deformability while maintaining the mechanical strength.

For the processing method, a sheet can be obtained by extruding a raw material which becomes the self-adhesive sheet 1 into a sheet shape using a net extrusion method or the like. For example, in the net extrusion method, while a resin composition is extruded from a nozzle of a rotary die for molding a net provided at a tip of an extruder, the resin composition is welded and molded into a net shape, and the obtained extruded net is passed through a water tank at a predetermined temperature. Thereby, a net-shaped or mesh-shaped sheet is obtained.

Further, in a case where the gap is a slit-shaped fine line, the slit may be formed in the molded self-adhesive sheet 1 by a known method.

[Deformability]

The self-adhesive sheet 1 preferably has deformability.

For example, when the self-adhesive sheet 1 is subjected to deformation processing into the shape of the above (3), the flexibility and stretchability of the self-adhesive sheet 1 can be further improved. In a case where the shape of the self-adhesive sheet 1 is deformed, the wiring 2 and the base material 3 may also be deformed into substantially the same shape. With this, the wiring board 10 as a whole can have deformability such as flexibility and/or stretchability.

Further, as shown in Fig. 4, in a case where a set of wavy slits for one cycle are formed in the substantially central portion of the self-adhesive sheet 1, the self-adhesive sheet 1 can be bent at the substantially central portion. With this, it is possible to obtain deformability such as bendability. In this case, the wiring 2 is processed into a wavy shape in the in-plane direction of the self-adhesive sheet 1 and is arranged between the set of wavy slits so that electricity can be conducted from one region to the other region through the folding line of the self-adhesive sheet 1.

Further, in order to enhance deformability, such as flexibility and/or stretchability, of the self-adhesive sheet 1, at least a part of the self-adhesive sheet 1 may be wavy (including a pleated shape and a bellows shape) along the in-plane direction (z-axis direction, thickness direction). In this case, the wiring 2 and the base material 3 are also preferably wavy (including a pleated shape and a bellows shape) along the in-plane direction (z-axis direction) (refer to Fig. 8). With this, the deformability such as flexibility and/or stretchability of the wiring board 10 as a whole can be further enhanced.

[Foam]

The self-adhesive sheet 1 of the present embodiment may be a foam depending on the application. As a result, the flexibility of the self-adhesive sheet 1 can be improved, the shape followability and the adhesion can be improved, the weight reduction can be achieved, and the texture can be easily improved. The foam has single cells and/or open cells.

In addition, in the present embodiment, the degree of air bubbles in the foam may be different in the thickness direction of the self-adhesive sheet 1 or may be uniform. For example, the density of the foam may increase from the outer surface of the self-adhesive sheet 1 toward the wiring 2. In this case, the density of the foam is relatively low on the outer surface side of the self-adhesive sheet 1, flexibility is obtained, and good adhesion is maintained. On the other hand, the density of the foam is relatively high on the wiring 2 side of the self-adhesive sheet 1, hardness is obtained, and the wiring 2 is easily protected.

The foam of the self-adhesive sheet 1 can be obtained by a known method. For example, in the method for producing the self-adhesive sheet 1 described later, the self-adhesive sheet can be obtained by using a resin composition as a raw material of the self-adhesive sheet 1 and a foaming agent, and foam-molding the mixture into a sheet shape by an extrusion molding machine.

Examples of the foaming agent used when molding the self-adhesive sheet 1 according to the present embodiment include a chemical foaming agent and a physical foaming agent.

Examples of the chemical foaming agent include sodium bicarbonate, ammonium bicarbonate, various carboxylate salts, sodium borohydride, azodicarbonamide, N,N-dinitrosopentamethylenetetramine, P,P-oxybis(benzenesulfonylhydrazide), azobisisobutyronitrile, paratoluene sulfonyl hydrazide, sodium bicarbonate, sodium citrate, and the like.

Examples of the physical foaming agent include carbon dioxide, nitrogen, or a mixture of carbon dioxide and nitrogen, and any of these can be supplied in any of a gaseous, liquid, or supercritical state.

It is preferable that the chemical foaming agent is uniformly mixed with the 4-methyl-1-pentene-based polymer-based resin composition which is the raw material of the self-adhesive sheet 1 before being put into the extrusion molding machine. In addition, in a case where carbon dioxide is used as the physical foaming agent, it is preferable that the 4-methyl-1-pentene-based polymer-based resin composition comes into a state of being kneaded and plasticized in the extrusion molding machine, and then is directly injected into the extrusion molding machine.

The expansion ratio of the self-adhesive sheet 1 is not particularly limited, and can be appropriately determined in consideration of various physical properties of the self-adhesive sheet 1.

[Surface Roughness]

The self-adhesive sheet 1 of the present embodiment may have fine unevenness on the outer surface depending on the application. With this the adhesive properties (self-adhesiveness) between the self-adhesive sheets 1 can be dramatically improved. As a result, for example, in a usage mode in which the self-adhesive sheets 1 face each other, the wiring board 10 is more satisfactorily fixed to the living body by fixing the self-adhesive sheets 1 to each other (by causing the self-adhesive sheets to adhere by themselves). Above these, a high adhesive strength in the in-plane direction of the self-adhesive sheet 1 can be obtained.

It should be noted that the outer surface of the self-adhesive sheet 1 is one surface of the wiring board 10 and is a surface on the living body side.

In the self-adhesive sheet 1 according to the present embodiment, it is preferable that the outer surface arithmetic average roughness Ra is in a range of 0.01 to 10 um and/or the ten-point average roughness Rz is 0.1 to 50 um. Whit this, good fixability (self-adhesiveness) can be obtained. The arithmetic average roughness Ra is more preferably 0.02 to 8 $\mu$m, and even more preferably 0.03 to 5 um. In addition, the ten-point average roughness Rz is more preferably 0.2 to 40 $\mu$m, and even more preferably 0.3 to 20 um.

In the present embodiment, by controlling the arithmetic average roughness Ra and/or the ten-point average roughness Rz, the variation in unevenness is effectively suppressed, and more uniform fixing power and holding power can be obtained on the entire surface of the self-adhesive sheet.

The method for adjusting the surface roughness of the self-adhesive sheet 1 according to the present embodiment is not particularly limited, and a known method can be used. For example, the adjustment may be performed by a method by mold molding such as embossing in a sheet production process, a method for transferring the surface shape of an interleaving paper (separator) by interposing the interleaving paper between sheets when winding up the sheet, polishing, and a blasting treatment, and the like.

The arithmetic average roughness Ra and the ten-point average roughness Rz can be measured according to JIS B0610-2001.

[Thickness]

The thickness of the self-adhesive sheet 1 according to the present embodiment is not particularly limited, but is preferably in a range of 0.01 mm or more and 30 mm or less, more preferably in a range of 0.01 mm or more and 10 mm or less, even more preferably in a range of 0.02 mm or more and 5 mm or less, and still more preferably in a range of 0.03 mm or more and 2 mm or less.

By setting the thickness of the self-adhesive sheet 1 according to the present embodiment to the above lower limit value or more, a good balance between shape followability, mechanical properties, moldability, moisture resistance, and the like can be obtained while improving fixability.

By setting the thickness of the self-adhesive sheet 1 according to the present embodiment to the above upper limit value or less, it is possible to improve lightness, appearance, and handleability while maintaining good fixability.

[Multilayer]

The self-adhesive sheet 1 of the present embodiment may be formed of a single layer or a multilayer. In a case of a multilayer, the layers may have different performances from each other. For example, a layer having air permeability and a layer made of a foam may be combined and laminated.

[Density]

The density measured according to ASTM D 1505 (underwater substitution method) of the self-adhesive sheet 1 according to the present embodiment is appropriately set according to the application, and is preferably 0.01 to 2.0 g/cm$^3$, more preferably 0.1 to 1.5 g/cm$^3$, and even more preferably 0.3 to 1.0 g/cm$^3$.

As each component (material) constituting the self-adhesive sheet 1 according to the present embodiment, the same components (materials) as those of the first embodiment can be used.

In addition, the self-adhesive sheet 1 according to the present embodiment may be formed of a single layer or a multilayer as in the first embodiment. In a case of a multilayer, at least one layer is required to be a layer containing the 4-methyl-1-pentene-based polymer (a1), and two or more layers may contain the 4-methyl-1-pentene-based polymer (a1).

In addition, the self-adhesive sheet 1 according to the present embodiment can be obtained by the same production method as in the first embodiment.

<Wiring 2>

The wiring 2 of the present embodiment is electrically connected to the electrode 4 and has conductivity.

The material constituting the wiring 2 is not particularly limited as long as the material is a conductive material, and any or both of (i) a conductive material itself having deformability and stretchability, and (ii) a conductive material itself not having deformability and stretchability may be used.

From the viewpoint of obtaining durability against deformation and stretching and contraction of the wiring 2, as (i) the conductive material itself having deformability and stretchability, for example, a material formed of a conductive resin composition including a resin and conductive particles may be used. The wiring 2 can be obtained by applying a method such as printing, etching, sputtering, and pasting to the conductive resin composition.

As the above resin, a general thermoplastic elastomer and a thermosetting elastomer, or a conductive resin can be used.

Examples of the conductive particles include particles formed of one or more selected from gold, silver, copper, nickel, palladium, platinum, carbon black, and the like.

The particle diameter of the conductive particles is preferably 1 nm to 500 nm, and more preferably 10 nm to 100 nm. By setting the particle diameter to the above lower limit value or more, the reactivity of the particles can be improved and the storage stability of the ink can be improved. By setting the particle diameter to the above upper limit value or more, the wiring layer 2 can be formed with a uniform thickness.

Among these, it is preferable that the conductive resin composition is formed of a conductive ink. The conductive ink is an ink having conductivity, and the wiring 2 having a desired shape can be formed by forming a print layer having a desired shape by printing, and then performing drying. In addition, after drying, a baking treatment may be optionally performed.

Examples of the conductive ink include those containing a conductive resin, carbon black, and a rubber component. Examples of the conductive resin include PEDOT: PSS (poly (3,4-ethylenedioxythiophene): poly (4-styrenesulfonic acid)), polypyrrole, polyaniline (PANI), and the like. Examples of the rubber component include polyurethane, styrene-butadiene-styrene block copolymer (SBS), styrene-(ethylene-butylene)-styrene block copolymer (SEBS), and natural rubber.

By using carbon black for the conductive ink, the hysteresis of the resistance change can be reduced. The content of carbon black is preferably 1.0% to 4.0% by mass, and more preferably 1.6% to 2.3% by mass. The content of the conductive resin in the conductive ink is preferably 0.1% to 1.0% by mass, and more preferably 0.3% to 0.5% by mass. The content of the rubber component in the conductive ink is preferably 10% to 20% by mass, and more preferably 12% to 15% by mass.

The conductive ink is obtained by mixing a conductive resin, carbon black, a rubber component, and the like with water as a dispersion medium. In addition, the content of the water in the conductive conduction ink is preferably 70% to 90% by mass, and more preferably 83% to 86%. The viscosity of the conductive ink is preferably 1 cps to 500 cps.

As a printing method using the conductive ink, a known method can be used, and for example, stencil printing, ink jet printing, flexographic printing, and the like are suitably used.

Even when (ii) the conductive material itself does not have deformability or stretchability, the deformability and stretchability can be obtained by devising the shape of the wiring 2 as described below.

A metal film is mentioned as a material itself that does not have stretchability in the wiring 2. Examples of the metal film include a plating film formed of one or more selected from copper, nickel, silver, gold, and tin. It is preferable to use copper from the viewpoint of conductivity. The thickness of the plating film is preferably 0.03 um to 100 $\mu$m, more preferably 1 pm to 35 $\mu$m, and even more preferably 3 um to 18 $\mu$m.

In addition, for example, the wiring 2 may include a first wiring layer in which a wiring pattern is formed using a conductive ink on the self-adhesive sheet 1, and a second wiring layer in which a plating film is formed on the first wiring layer. Further, in the boundary region between the first wiring layer and the self-adhesive sheet 1, a part of the self-adhesive sheet 1 may be inserted in the voids of the first wiring layer. With this, the joining of the self-adhesive sheet 1 and the wiring 2 can be enhanced.

The thickness of the wiring 2 is smaller than the thickness of the wiring board 10 and the electronic device 11, and is, for example, preferably 50 um or less, and more preferably 30 um or less. The width of the wiring 2 is, for example, 50 um or more and 10 mm or less.

The wiring 2 of the present embodiment is preferably processed into a parallel line shape, a wavy shape, a pleated shape, a grid shape, a mesh shape (net shape), a honeycomb shape, or a dot shape in the in-plane direction (in the xy plane). These shapes may be a combination of one or two or more shapes. In addition, it is sufficient that at least a part of the wiring 2 has such a shape. This makes it possible to extend the wiring board while deforming or stretching along the skin and movement of the living body. As a result, the feeling of wearing of the wiring board 10 and the electronic device 11 can be improved, the electrical conductivity of the electronic device 11 can be stabilized, and a good electric signal can be obtained.

Among these, since the wiring 2 has a parallel linear shape, a wavy shape, a pleated shape, a grid shape, and a mesh shape (net shape) in the in-plane direction (in the xy plane), even in a case where (ii) the conductive material itself does not have deformability and stretchability, deformability and stretchability can be obtained by stretching and contracting the wiring 2 itself in a bellows shape or a spring shape.

The wiring 2 is required to be covered with the self-adhesive sheet 1 to an extent that leakage and discharge can be suppressed, and may have substantially the same shape as the self-adhesive sheet 1 or may have a different shape. The wiring 2 is appropriately designed according to the shape and deformability of the self-adhesive sheet 1.

At least a part of the wiring 2 of the present embodiment may be wavy (including a pleated shape and a bellows shape) along the in-plane direction (z-axis direction) of the wiring board 10 (refer to Fig. 8). That is, a part of the wiring 2 has a pleated shape or a bellows shape in which a plurality of peaks and valleys are alternately arranged in the thickness direction of the wiring board 10. With this, in a case where the wiring board 10 is in a relaxed state, the wiring 2 has a plated or bellows-shaped portion in which peaks and valleys repeatedly appear along the in-plane direction of the wiring board 10, and in a case where the wiring board 10 is stretched, the bellows-shaped portion of the wiring 2 can be expanded in the in-plane direction. As a result, the stretchability of the wiring 2 is obtained, and in combination with the stretchability of the self-adhesive sheet 1, the wiring board 10 can satisfactorily follow the skin and movement of the living body to improve adhesion. In this case, the self-adhesive sheet 1 may also have a wavy shape (pleated shape or bellows shape) along the in-plane direction (z-axis direction) of the wiring board 10, and in a case where the self-adhesive sheet 1 itself stretches and contracts, the wiring board may not have the plated portion or the bellows-shaped portion.

<Base Material 3>

In the present embodiment, the wiring board 10 has the base material 3 on the surface of the wiring 2 opposite to the surface on which the self-adhesive sheet 1 is provided. This makes it possible to increase the mechanical strength of the wiring board 10 and expand the degree of freedom in design such as providing additional functions.

In addition, the base material 3 is located on the side farther from the living body or the like than the self-adhesive sheet 1 when the wiring board 10 is used for the living body or the like. It should be noted that as shown in Fig. 1, when the wiring board 9 includes the self-adhesive sheet 1 and the wiring 2, the self-adhesive sheet 1 and the base material 3 are common.

The base material 3 is preferably formed to have stretchability. The stretchability may be obtained by a material having stretchability, or may be obtained by devising the shape and structure even when the material itself does not have stretchability, or both may be used.

The material constituting the base material 3 is not particularly limited, and synthetic resins such as thermoplastic elastomer, silicone rubber, urethane gel, and silicone gel; cloths such as woven fabric, knitted fabric, and non-woven fabric can be used. Examples of the thermoplastic elastomer include a polyurethane-based elastomer, a styrene-based thermoplastic elastomer, an olefin-based thermoplastic elastomer, a vinyl chloride-based thermoplastic elastomer, an ester-based thermoplastic elastomer, an amide-based thermoplastic elastomer, a butadiene-based thermoplastic elastomer, and a fluorine-based thermoplastic elastomer.

Further, the material constituting the base material 3 may be the same as the material constituting the self-adhesive sheet 1. This makes it possible to simplify the production process and improve the adhesion of the joining region between the self-adhesive sheet 1 and the base material 3 while obtaining good deformability such as flexibility and/or stretchability.

The thickness of the base material 3 is, for example, 10 um or more and 10 mm or less, and preferably 100 um or more and 1 mm or less. By setting the thickness of the base material 3 to the above lower limit value or more, the wiring 2 can be protected and the mechanical strength of the wiring board 10 can be maintained. On the other hand, by setting the thickness of the base material 3 to the above upper limit value or less, the force required for stretching and contraction can be reduced, and the wiring board 10 can be easily made thinner and lighter. Further, it is possible to reduce the feeling of wearing when the electronic device 11 using the wiring board 10 is attached to the living body.

The base material 3 can have the same structure as the self-adhesive sheet 1 or the wiring 2 described above in order to obtain deformability such as flexibility and/or stretchability. That is, the base material 3 may be processed into a parallel line shape, a wavy shape, a grid shape, a mesh shape (net shape), a honeycomb shape, or a dot shape in the in-plane direction (in the xy plane). Further, at least a part of the base material 3 may be wavy (bellows-shaped) along the in-plane direction (z-axis direction) of the wiring board 10 (refer to Fig. 8). With this, the deformability of the entire wiring board 10 is enhanced, the skin and movement of the living body can be satisfactorily followed, and the adhesion can be improved.

<Electrode 4>

The electrode 4 comes into contact with a living body and receives an electrical signal.

The electrode 4 is not particularly limited as long as the electrode is formed of a conductive material, and can be obtained by using the same material as the wiring 2 described above. The method for forming the electrode 4 is not particularly limited, and a known method can be used. Among these, a conductive ink is suitably used from the viewpoint of easily forming a desired shape.

The ratio of the exposed area of the electrode 4 to the outer surface area of the self-adhesive sheet 1 is not particularly limited, and is appropriately set according to the location and application of the electrode 4.

<Others>

The wiring board 10 of the present embodiment may further include a configuration other than the above.

For example, a layer for suppressing stuffiness or absorbing sweat or the like, a layer for suppressing friction, a layer having waterproof properties, and the like can be mentioned. As for these layers, known ones can be used by a known method as long as the surface on the self-adhesive sheet 1 side can be attached to the skin of the living body and does not interfere with the energization of the electrode 4.

In addition, the wiring board 10 may include a reinforcing member for protecting an electronic component electrically connected to the wiring 2. From the viewpoint of protecting the electronic component from stress due to deformation or the like, the reinforcing member is suitably one that is less likely to be deformed than the self-adhesive sheet 1 and the base material 3. Alternatively, the reinforcing member may be intended for waterproofing, heat resistance, or weather resistance.

In addition, the surface of the wiring board 10 on the side to be attached to the living body is appropriately set according to the application, but from the viewpoint of easily enhancing the adhesion, it is preferable that the entire surface is formed of the self-adhesive sheet 1.

Further, it is preferable that the wiring board 10 has a sucker-shaped recess portion that is gently curved in a part of the outer surface of the self-adhesive sheet 1. With this, by pressing the self-adhesive sheet 1 against the skin of the living body or the like, the sucker-shaped recess portion is crushed and air is released, so that a suction action can be generated on the living body contact surface of the wiring board 10. Therefore, the adhesion of the wiring board 10 or the electronic device 11 to the living body is improved. On the other hand, when the wiring board 10 or the electronic device 11 is removed from the living body, the suction action is lost by peeling only the outer edge portion of the wiring board 10 or the electronic device 11 (self-adhesive sheet 1) from the skin, and the self-adhesive sheet 1 can be easily separated from the living body.

The size of the sucker-shaped recess portion is not particularly limited as long as the wiring board 10 or the electronic device 11 can appropriately come into close contact with the living body.

Further, it is preferable that in the wiring board 10, the thickness of the outer edge portion is smaller than that of the central portion. In addition, when the surface of the wiring board 10 on the self-adhesive sheet 1 side is brought into contact with a flat surface, the surface of the wiring board 10 is suitably gently inclined from the region located slightly inner side from the outer edge of the wiring board 10 toward the outer edge portion of the wiring board. With this, in the wiring board 10 or the electronic device 11 attached to the living body by the suction action, the outer edge of the wiring board 10 is likely to satisfactorily come into close contact with the living body. Thus, a gap can be prevented from being formed between the self-adhesive sheet 1 and the living body due to the outer edge being caught, and the deterioration of the suction action can be reduced.

<Method for Producing Wiring Board 10>

The wiring board 10 of the present embodiment can be produced, for example, as follows.

The wiring 2 is provided on the base material 3. Examples of the method for providing the wiring 2 include a method for performing printing with a conductive ink on the base material 3. Subsequently, the electrode 4 electrically connected to the wiring 2 is provided on the base material 3.

Next, the self-adhesive sheet 1 is arranged on the wiring 2 so that at least a part of the electrode 4 is exposed, and covers the wiring 2. As the method for arranging the self-adhesive sheet 1, the material of the self-adhesive sheet 1 may be dissolved in an organic solvent to form a varnish, and the varnish may be applied onto the wiring 2 and dried to arrange the self-adhesive sheet 1. Alternatively, the self-adhesive sheet 1 may be arranged on the wiring 2 by extrusion lamination.

Alternatively, the self-adhesive sheet 1 may be further laminated on the wiring 2 after the wiring 2 is arranged on the self-adhesive sheet 1, and after the self-adhesive sheet 1 is formed, a part of the self-adhesive sheet 1 may be removed and the wiring 2 may be embedded.

«Electronic Device»

The electronic device 11 of the present embodiment includes the wiring board 10 described above, the electrode 4 exposed in the opening of the self-adhesive sheet 1, and an electronic component electrically connected to the wiring 2.

Examples of the electronic component include a sensor; a transistor, large-scale integration (LSI), micro electromechanical systems (MEMS), a relay, a light emitting element such as LEDs, OLEDs, and LCDs; a sounding component such as a buzzer; a vibration component that generate vibrations; a cooling and heating component such as a Pelche element that controls cooling and heating, and a heating wire; a resistor, a capacitor, an inductor, a piezoelectric element, a switch, and a connector.

Examples of the sensors include a temperature sensor, a pressure sensor, a piezoelectric sensor, an optical sensor, a photoelectric sensor, a proximity sensor, a shear force sensor, a biosensor, a laser sensor, a microwave sensor, a humidity sensor, a strain sensor, a gyro sensor, an acceleration sensor, a displacement sensor, a magnetic sensor, a gas sensor, a GPS sensor, an ultrasonic sensor, an odor sensor, a brain wave sensor, a current sensor, a vibration sensor, a pulse wave sensor, an electrocardiographic sensor, and a photometric sensor. Among these, a biosensor is preferable. The biosensor can measure biological information such as heartbeat, pulse, electrocardiogram, blood pressure, body temperature, blood oxygen concentration, myoelectricity, brain wave, body temperature, and muscle activity.

<Application>

As application, the wiring board can be used in all fields where electronic devices are required. In particular, since the wiring board has good adhesion to a living body, the wiring board can be used in application for contact with the human body. For example, the wiring board is used in a wide range of fields such as apparel, fashion accessories, sports, outdoors, medical care, nursing care, housing, furniture, bedding, stationery, toys, mobility (automobiles, aircraft, trains, and the like), home appliances, displays, wearables, sensors, robots, and the like. Among these, the wiring board can be used for various wearable devices since the wiring board is brought into close contact with the complicated shape of the body and accurate biological information can be obtained. For example, the wiring board can be used in smart watches, smart glasses, virtual reality (VR) devices, augmented reality (AR) devices, e-sports devices, techno sports devices, robot suits, biological sensing devices, soft robotics devices, skin displays, and the like. In addition, with the advent of the IoT era in which information is obtained from all things, the wiring board can be suitably used for anything that comes into contact with the body. For example, the wiring board can be used in hats, helmets, wigs, headphones, earphones, hearing aids, eyeglasses, masks, face masks, accessories (pierces, earrings, necklaces, bracelets, rings, and the like), watches, underwear, shirts, pants, trousers, skirts, belts, supporters, wristbands, mufflers, socks, shoes (sneakers, pumps, leather shoes, boots, sandals, and the like), slippers, leg guards, protectors, protective tools, protective clothing, seats (automobile seats, aircraft seats, train seats, sofas, office chairs, and the like), cushion, bedding (bed, mattress, and the like), pillows, grips (related to sports such as golf, stationery such as pen, and the like), mobile phones, personal computers, various displays (touch panels, and the like), remote controllers, switches, various medical devices (thermometers, pulse rate monitors, sphygmomanometers, electrocardiogram, electromyogram, electroencephalograph, high-precision measurements for body parts, and the like), various medical products (hemostatic bands, and the like), and the like. The wiring board can also be used for application for monitoring complex movements of the human body, stretching and contraction movements, violent movements, and movements of objects moving at high speed by taking advantage of its excellent stretchability and flexibility. In addition, since the wiring board has a high affinity with soft materials other than those that come into contact with the body, it can be used in various fields and applications that require measurement of soft and stretchable materials. For example, the wiring board can be used for measuring the motion of soft parts (tubes, or the like) of equipment, measuring changes in the shape of clothing, shoes, and the like.

<Third Embodiment>

Next, an embodiment of a third invention will be described. It should be noted that the same configurations and effects as those of the first embodiment will not be repeated as appropriate.

A sealing member of the present disclosure includes a self-adhesive member having a self-adhesive surface, an opening and closing portion is formed by causing the self-adhesive surfaces to face each other, the opening and closing portion is opened when the facing self-adhesive surfaces are separated from each other, and is closed when the facing self-adhesive surfaces are caused to adhere to each other, and the self-adhesive member contains a polymer satisfying the following Requirement 1.

(Requirement 1)

In the polymer, at least one temperature showing a local maximum value of a loss tangent (tan $\delta$), which is measured by dynamic viscoelasticity measurement under conditions of a temperature rising rate of 4 °C/min, a frequency of 1.59 Hz, and a strain amount of 0.1%, is present in a range of 10°C or higher and 100°C or lower, and the local maximum value is 0.5 or more and 3.5 or less.

In the present embodiment, the self-adhesive member is formed of a self-adhesive sheet, and the self-adhesive sheet satisfies the above requirement 1.

When the sealing member of the present disclosure has the above configuration, it is possible to provide a sealing member having excellent airtightness of the opening and closing portion in an environment close to normal temperature.

The excellent airtightness of the opening and closing portion means that the airtightness of the opening and closing portion is excellent in a state in which a penetration member such as a tube is fixed to the opening and closing portion, and airtightness of the opening and closing portion is excellent in a state in which other members such as a penetration member are not fixed to the opening and closing portion.

That is, the sealing member of the present disclosure is arranged so that the self-adhesive surfaces of the self-adhesive sheets having the self-adhesive surfaces face each other, and the self-adhesive surfaces are detachably attached. Thus, an opening portion is formed by separating the facing self-adhesive surfaces from each other, and the opening portion is closed by causing the facing self-adhesive surfaces to adhere to each other.

It should be noted that the above-mentioned penetration member is a member having a size capable of passing through the opening portion formed by the sealing member of the present disclosure and being free to pass through the opening portion. That is, the penetration member is not limited to a member itself having a penetration portion. Further, the penetration member may be interposed between the self-adhesive surfaces forming the opening portion when the opening portion of the sealing member of the present disclosure is closed.

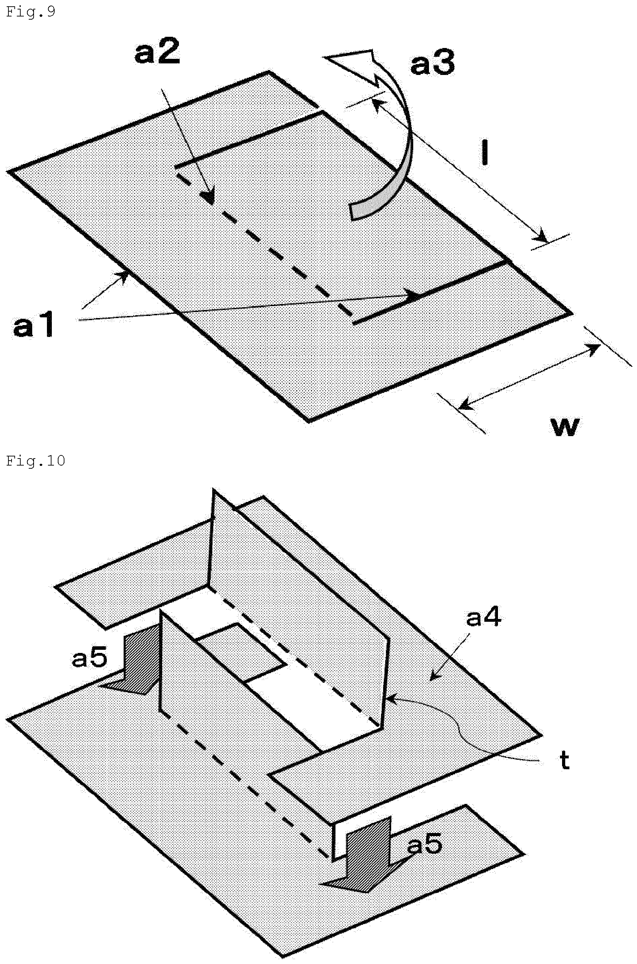

An embodiment of the method for producing the opening and closing portion in the present disclosure will be described with reference to Figs. 9 and 10.

Fig. 9 is a schematic view showing an embodiment of the self-adhesive member used to surround the opening and closing portion.

As the self-adhesive members surrounding the opening and closing portion, for example, two self-adhesive members having an appropriate thickness as shown in Fig. 9 are prepared in the same size. The prepared self-adhesive member is cut out along a cutting line a1, bent along a bending line a2 in the vertical direction as a bending direction a3, and processed so that a length 1 of the opening and closing portion and a width w of the opening and closing portion have desired values.

The thickness (t) of the self-adhesive member may be appropriately adjusted.

For example, the thickness (t) of the self-adhesive member can be adjusted by the outer diameter of the penetration member in a case where there is a member (also referred to as a penetration member) interposed in the opening and closing portion.

In a case where the outer diameter of the penetration member is relatively large (for example, 10 $\varphi$ to 30 $\varphi$), t may be set relatively thick (for example, 100 um to 250 um).

In a case where the outer diameter of the penetration member is relatively small (for example, 1 $\varphi$ to 20 $\varphi$), t may be set relatively thick (for example, 50 um to 150 um).

Fig. 10 is a schematic view for explaining a method for producing the opening and closing portion by overlapping the self-adhesive members after processing.

As shown in Fig. 10, each of the self-adhesive members a4 having the thickness t after processing is overlapped in the vertical direction as an overlapping direction a5 so that the surfaces cut out in the above processing face each other. With this, the opening and closing portion surrounded by the self-adhesive members can be obtained.

<Self-Adhesive Member>

The sealing member of the present disclosure includes a self-adhesive member having a self-adhesive surface, and the self-adhesive member contains a polymer satisfying the following requirement 1.

(Requirement 1)

In the polymer, at least one temperature showing a local maximum value of a loss tangent (tan $\delta$), which is measured by dynamic viscoelasticity measurement under conditions of a temperature rising rate of 4 °C/min, a frequency of 1.59 Hz, and a strain amount of 0.1%, is present in a range of 10°C or higher and 100°C or lower, and the local maximum value is 0.5 or more and 3.5 or less.

In the present embodiment, the self-adhesive member is formed of a self-adhesive sheet, and the self-adhesive sheet satisfies the above requirement 1.

The self-adhesive member having the above configuration is gradually softened as the temperature reaches about 30°C to 35°C, which is close to the temperature of the human skin. Then, the adhesive portion can be peeled off with a slight external force to secure the opening portion. In addition, the self-adhesive member having the above configuration is softened by raising the temperature to about 36°C to 40°C in a state in which the opening portion is secured, to maximize the adhesive force, and the penetration member is easily

interposed in the opening portion.

As a result, the adhesive surfaces can be satisfactorily brought into close contact with each other in a state in which the penetration member is interposed in the opening portion by interposing the penetration member in the opening portion and then closing the self-adhesive members. On the other hand, when the self-adhesive member is maintained by lowering the temperature outside the above temperature range (for example, 23°C close to normal temperature), the adhesive surfaces can be solidified while being in close contact with each other. That is, it is possible to maintain a state in which the self-adhesive materials are caused to adhere to each other.

As described above, the sealing member of the present disclosure has excellent airtightness of the opening and closing portion. In addition, as described above, the sealing member of the present disclosure also has excellent opening and closing easiness of the opening and closing portion.

(Self-Adhesive Surface)

The self-adhesive member has a self-adhesive surface arranged in the opening and closing portion.

The self-adhesive surfaces are arranged so as to face each other.

In addition, the opening and closing portion is opened when the facing self-adhesive surfaces are separated from each other, and is closed when the facing self-adhesive surfaces are caused to adhere to each other.

With this, it is possible to adjust the opening and closing of the opening and closing portion. In addition, the sealing performance of the sealing member can be improved in the closed state.

[Polymer]

The self-adhesive member contains a polymer that satisfies the following requirement 1.

(Requirement 1)

In the polymer, at least one temperature showing a local maximum value of a loss tangent (tan $\delta$), which is measured by dynamic viscoelasticity measurement under conditions of a temperature rising rate of 4 °C/min, a frequency of 1.59 Hz, and a strain amount of 0.1%, is present in a range of 10°C or higher and 100°C or lower, and the local maximum value is 0.5 or more and 3.5 or less.

The details of the reason for this are not clear, but the reason may be considered as follows.

First, by increasing the loss tangent (tan $\delta$) of the polymer in a relatively low frequency region of 1.59 Hz, the self-adhesive surface easily follows a force (also referred to as a slow force) applied over time, compared to a force such as a momentary impact. Therefore, it is presumed that the surface shapes of the self-adhesive surfaces follow each other due to the force applied when the self-adhesive surfaces are caused to adhere to each other, when used after adhesion, or the like, and the fixing power against the force to pull the sheets apart (in particular, a force applied in a planar direction) is enhanced.

Further, since the self-adhesive surface contains the polymer in which the local maximum value of the loss tangent is within the above range in a range of 10°C or higher and 100°C or lower, and thus can convert more of the mechanical energy given at the time of deformation into thermal energy and can absorb a large amount of energy, it is considered that the restoration speed after deformation becomes slow. As a result, it is considered that it is possible to satisfactorily follow the deformation while maintaining the flexibility of the self-adhesive sheet, and as a result, the fixability can be improved.

[Temperature Showing Local maximum value of Loss Tangent (tan $\delta$)]

In the self-adhesive member in the present disclosure, it is preferable that the polymer has at least one or more temperatures showing the local maximum value of the loss tangent (tan $\delta$) in a range of 10°C or higher and 80°C or lower, it is more preferable that the polymer has one or more temperatures showing the local maximum value of the loss tangent in a range of 10°C or higher and 60°C or lower, it is even more preferable that the polymer has one or more temperatures showing the local maximum value of the loss tangent in a range of 10°C or higher and 50°C or lower, and it is particularly preferable that the polymer has one temperature showing the local maximum value of the loss tangent in a range of 10°C or higher and 50°C or lower.

With this, in a case where the self-adhesive member is in contact with human skin at about 36°C to 40°C, or in a case where the self-adhesive member is arranged at a position close to the human body, the self-adhesive member is softened and the adhesive force between the self-adhesive surfaces becomes maximum. As a result, it is possible to more easily bring the self-adhesive surfaces into close contact with each other.

On the other hand, in a case where the self-adhesive member is maintained in a temperature range outside the above temperature range (for example, normal temperature of 23°C), the solidified state is maintained as it is and good adhesion can be obtained. As a result, the self-adhesive surfaces can be caused to more firmly adhere to each other.

[Local maximum value of Loss Tangent (tan $\delta$)]

In the self-adhesive member in the present disclosure, the local maximum value of the loss tangent of the polymer is 0.5 or more and 3.5 or less.

From the above viewpoint, the local maximum value of the loss tangent is preferably 0.8 or more, more preferably 1.0 or more, even more preferably 1.2 or more, and particularly preferably 2.0 or more.

In the polymer in the present disclosure, the local maximum value of the loss tangent is preferably 3.0 or less, and more preferably 2.8 or less.

As a result, it is possible to improve the performance balance between flexibility and shape followability while obtaining the fixability of the self-adhesive member in the present disclosure.

Here, the larger the local maximum value of the loss tangent, the stronger the viscous property of the self-adhesive member. It is thought that the self-adhesive member, which has strong viscous properties, can convert more of mechanical energy given at a time of deformation into thermal energy and absorb more energy, the restoration speed after deformation becomes more moderate. As a result, it is considered that while maintaining flexibility of the self-adhesive member, the shape after deformation can be more satisfactorily maintained, the deformation can be followed more satisfactorily, or the fixability to the planar direction can be improved.

As described above, in the present disclosure, the loss tangent (tan $\delta$) of the polymer is measured by dynamic viscoelasticity measurement under the conditions of temperature rising rate of 4 °C/min, a frequency of 1.59 Hz, and a strain amount of 0.1%.

For example, the self-adhesive member containing a polymer can be cut into a test piece having a size of 50 mm in length $\times$ 5 mm in width, and measurement can be performed using a rheometer under the conditions of a frequency of 1.59 Hz, a temperature rising rate of 4 °C/min, a measurement temperature range of 0°C to 110°C, a strain amount of 0.1%, a chuck-to-chuck distance of 20 mm, and a tensile mode.

The loss tangent of the polymer in the present disclosure can be controlled to be in the above range, for example, by appropriately adjusting (1) the kind and mixing ratio of a 4-methyl-1-pentene-based polymer (a1) described later, (2) the presence or absence of crosslinking of the sheet, (3) a method for molding the self-adhesive member, and the like.

Specifically, for example, the mixing ratio of the 4-methyl-1-pentene-based polymer (a1) in the self-adhesive member may be increased, and the sheet may not be crosslinked.

In the self-adhesive member in the present disclosure, from the viewpoint of improving fixability, the polymer is preferably uncrosslinked. That is, it is preferable that the self-adhesive member in the present disclosure is an uncrosslinked sheet that has not been subjected to a crosslinking treatment such as ionization radiation crosslinking using an electron beam or $\gamma$-ray, for example.

With this, the local maximum value of the loss tangent in a range of 10°C or higher and 100°C or lower can be improved, and a self-adhesive member having more excellent fixability can be obtained.

As the polymer in the present disclosure, any polymer satisfying the above-mentioned (Requirement 1) can be used without particular limitation.

Examples of the polymer include olefin-based polymers, and among these, a 4-methyl-1-pentene-based polymer is preferable.

[4-Methyl-1-Pentene-Based Polymer]

The polymer in the present disclosure preferably contains a 4-methyl-1-pentene-based polymerization (a1).

With this, the local maximum value of the loss tangent (tan $\delta$) can be made larger.

As the 4-methyl-1-pentene-based polymer (a1) in the present disclosure, a 4-methyl-1-pentene·$\alpha$-olefin copolymer (c) including a constitutional unit (c1) derived from 4-methyl-1-pentene and a constitutional unit (c2) derived from an $\alpha$-olefin having 2 to 20 carbon atoms other than the 4-methyl-1-pentene is preferable.

That is, it is preferable that the polymer in the present disclosure includes a 4-methyl-1-pentene-based polymer, and the 4-methyl-1-pentene-based polymer includes a constitutional unit derived from 4-methyl-1-pentene and a constitutional unit derived from an $\alpha$-olefin having 2 to 20 carbon atoms other than the 4-methyl-1-pentene.

Here, in the present disclosure, the term "a-olefin having 2 to 20 carbon atoms" does not include 4-methyl-1-pentene unless otherwise specified.

In the 4-methyl-1-pentene·$\alpha$-olefin copolymer (c) in the present disclosure, from the viewpoint of further improving flexibility and fixability of the self-adhesive member, when a sum of the constitutional unit (c1) and the constitutional unit (c2) is 100 mol%, it is preferable that a content of the constitutional unit (c1) is 10 mol% or more and 90 mol% or less, and a content of the constitutional unit (c2) is 10 mol% or more and 90 mol% or less. In addition, in the 4-methyl-1-pentene·$\alpha$-olefin copolymer (c) in the present disclosure, from the viewpoint of further improving flexibility, mechanical properties, or the like of the self-adhesive member, when the sum of the constitutional unit (c1) and the constitutional unit (c2) is 100 mol%, it is more preferable that the content of the constitutional unit (c1) is 30 mol% or more and 90 mol% or less, and the content of the constitutional unit (c2) is 10 mol% or more and 70 mol% or less, it is even more preferable that the content of the constitutional unit (c1) is 50 mol% or more and 90 mol% or less, and the content of the constitutional unit (c2) is 10 mol% or more and 50 mol% or less, it is still even more preferable that the content of the constitutional unit (c1) is 60 mol% or more and 90 mol% or less and the content of the constitutional unit (c2) is 10 mol% or more and 40 mol% or less, and it is particularly preferable that the content of the constitutional unit (c1) is 65 mol% or more and 90 mol% or less and the content of the constitutional unit (c2) is 10 mol% or more and 35 mol% or less.

In the present disclosure, examples of the $\alpha$-olefin having 2 to 20 carbon atoms used in the 4-methyl-1-pentene·$\alpha$-olefin copolymer (c) includes a linear or branched $\alpha$-olefin, a cyclic olefin, an aromatic vinyl compound, a conjugated diene, a functionalized vinyl compound, and the like, and the linear $\alpha$-olefin is preferable.

The number of carbon atoms of the linear $\alpha$-olefin is preferably 2 to 10, more preferably 2 to 5, and even more preferably 2 to 3. Examples of the linear $\alpha$-olefin include ethylene, propylene, 1-butene, 1-pentene, and the like. One kind or two or more kinds selected from ethylene, propylene, 1-butene, 1-pentene, 1-hexene, 1-octene, and 1-decene are preferable, and at least one kind selected from ethylene and propylene is more preferable.

The number of carbon atoms of the branched $\alpha$-olefin is preferably 5 to 20, and more preferably 5 to 15. Examples of the branched $\alpha$-olefin include 3-methyl-1-butene, 3-methyl-1-pentene, 3-ethyl-1-pentene, and the like.

The number of carbon atoms of the cyclic olefin is preferably 5 to 15. Examples of the cyclic olefin include cyclopentene, cyclohexene, cycloheptene, norbornene, 5-methyl-2-norbornene, tetracyclododecene, vinylcyclohexane, and the like.

Examples of the aromatic vinyl compound include mono- or poly-alkylstyrenes such as styrene, $\alpha$-methylstyrene, o-methylstyrene, m-methylstyrene, p-methylstyrene, o,p-dimethylstyrene, o-ethylstyrene, m-ethylstyrene, p-ethylstyrene, and the like.

The number of carbon atoms of the conjugated diene is preferably 4 to 20, and more preferably 4 to 10. Examples of the conjugated diene include 1,3-butadiene, isoprene, chloroprene, 1,3-pentadiene, 2,3-dimethylbutadiene, 4-methyl-1,3-pentadiene, 1,3-hexadiene, 1,3-octadiene, and the like.

Examples of the functionalized vinyl compound include unsaturated carboxylic acids such as a hydroxyl group-containing olefin, a halogenated olefin, a (meth) acrylic acid, a propionic acid, a 3-butenoic acid, a 4-pentenoic acid, a 5-hexenoic acid, a 6-heptenoic acid, a 7-octenoic acid, an 8-nonenoic acid, a 9-decenoic acid, and a 10-undecenoic acid, and acid anhydrides or acid halides thereof, unsaturated amines such as allylamine, 5-hexenamine, 6-hepteneamine, and the like, (2,7-octadienyl) succinic anhydride, pentapropenyl succinic anhydride, an unsaturated epoxy compound, an ethylenically unsaturated silane compound, and the like.

Examples of the hydroxyl group-containing olefin include a linear or branched terminal hydroxylated $\alpha$-olefin having 2 to 20 carbon atoms, and preferably 2 to 15 carbon atoms, and the like.

Examples of the halogenated olefin include a linear or branched halogenated $\alpha$-olefin having 2 to 20 carbon atoms, and preferably 2 to 15 carbon atoms, and the like.

These $\alpha$-olefins having 2 to 20 carbon atoms can be used alone or in combination of two or more kinds thereof. Among these, ethylene and propylene are preferable, but the use of propylene is particularly preferable from a viewpoint of further improving flexibility and the like.

The 4-methyl-1-pentene·$\alpha$-olefin copolymer (c) may contain constitutional units other than the constitutional unit (c1) and the constitutional unit (c2) within a range of not impairing the object of the present disclosure. Other constitutions include constitutional units derived from non-conjugated polyene.

Examples of the non-conjugated polyene include a linear, branched, or cyclic diene having preferably 5 to 20 carbon atoms, and more preferably 5 to 10 carbon atoms, various norbornenes, norbornadienes, and the like. Among these, 5-vinylidene-2-norbornene and 5-ethylidene-2-norbornene are preferable.

From a viewpoint of further improving flexibility or mechanical strength of the self-adhesive member, the intrinsic viscosity [η] in decalin of 135°C of the 4-methyl-1-pentene-based polymer according to the present disclosure is preferably 0.01 to 5.0 dL/g, more preferably 0.1 to 4.0 dL/g, even more preferably 0.5 to 3.0 dL/g, and particularly preferably 1.0 to 2.8 dL/g.

The density of the 4-methyl-1-pentene-based polymer in the present disclosure, measured by ASTM D 1505 (underwater substitution method), is preferably 0.810 to 0.850 g/cm$^3$, more preferably 0.820 to 0.850 g/cm$^3$, and even more preferably 0.830 to 0.850 g/cm$^3$.

The 4-methyl-1-pentene-based polymer in the present disclosure can be produced by various methods. For example, it is possible to produce the 4-methyl-1-pentene-based polymer by using known catalysts such as magnesium-supported titanium catalysts; metallocene catalysts described in International Publication No. WO 01/53369, International Publication No. WO 01/027124, Japanese Unexamined Patent Publication No. H03-193796, Japanese Unexamined Patent Publication No. H02-41303, and the like; olefin polymerization catalysts containing a metallocene compound described in International Publication No. WO 2011/055803, and the like.

Although the content of the 4-methyl-1-pentene-based polymer (a1) in the self-adhesive member in the present disclosure is not particularly limited, when the entire content of the self-adhesive member is 100% by mass, the content of the 4-methyl-1-pentene-based polymer (a1) is preferably 50% by mass or more, more preferably 60% by mass or more, even more preferably 65% or more by mass, still even more preferably 70% by mass or more, and particularly preferably 75% by mass or more, and preferably 100% by mass or less, more preferably 99.5% by mass or less, even more preferably 99% by mass or less, still even more preferably 98% by mass or less, and particularly preferably 97% by mass or less.

With this, it is possible to obtain a self-adhesive member having excellent balance between impact absorption properties, flexibility, shape followability, lightness, mechanical properties, handleability, appearance, moldability, moisture resistance, and the like.

The self-adhesive member in the present disclosure may contain components other than the above-mentioned 4-methyl-1-pentene-based polymer (a1).

[Modified Resin (a2)]

From a viewpoint of further improving appearance, texture, and fixability, the self-adhesive member in the present disclosure may contain a modified resin (a2) (here, the 4-methyl-1-pentene-based polymer (a1) in the present disclosure is excluded). Examples of the modified resin (a2) in the present disclosure include one kind or two or more kinds selected from a thermoplastic resin, a thermoplastic elastomer, and a rubber.

Examples of the thermoplastic resin (here, the 4-methyl-1-pentene-based polymer (a1) in the present disclosure is excluded) include thermoplastic polyolefin resins such as low-density polyethylene (also referred to as LDPE), medium-density polyethylene, high-density polyethylene, high-pressure low-density polyethylene (also referred to as LLDPE), polypropylene, poly 1-butene, poly 4-methyl-1-pentene, poly 3-methyl-1-butene, ethylene·α-olefin copolymer, propylene·α-olefin copolymer, 1-butene·α-olefin copolymer, cyclic olefin copolymer, and chlorinated polyolefin; thermoplastic polyamide-based resins such as aliphatic polyamide (nylon 6, nylon 11, nylon 12, nylon 66, nylon 610, nylon 612) and polyether block amide copolymer; thermoplastic polyester-based resins such as polyethylene terephthalate and polybutylene terephthalate; thermoplastic vinyl aromatic resins such as polystyrene, ABS resin, and AS resin; vinyl chloride resins; vinylidene chloride resins; acrylic resins; ethylene-vinyl acetate copolymers; ethylene-methacrylic acid acrylate copolymers; ionomers; ethylene-vinyl alcohol copolymers; polyvinyl alcohols; fluorine-based resins such as polyvinyl fluoride resin, polytetrafluoroethylene, polyvinylidene fluoride, and ETFE; polycarbonate; polyacetal; polyphenylene oxide; polyphenylene sulfide; polyimide; polyarylate; polysulfone; polyether sulfone; rosin-based resins; terpene-based resins; petroleum resins; and the like.

Examples of the rubber include ethylene·α-olefin·diene copolymer rubber, propylene·α-olefin·diene copolymer rubber, and the like.

In addition, examples of the thermoplastic elastomer include an olefin-based elastomer, a styrene-based elastomer, an acid-modified styrene-based elastomer, a vinyl chloride-based elastomer, a urethane-based elastomer, an ester-based elastomer, an amide-based elastomer, and the like.

In addition, these modified resins (a2) optionally be modified by acid with acrylic acid, methacrylic acid, maleic acid, or the like.

These modified resins (a2) may be used alone or in combination of two or more kinds thereof.

Among these modified resins (a2), one kind or two or more kinds selected from low-density polyethylene, medium-density polyethylene, high-density polyethylene, high-pressure low-density polyethylene, polypropylene, poly 1-butene, poly 4-methyl-1-pentene, poly 3-methyl-1-butene, ethylene·α-olefin copolymer, propylene·α-olefin copolymer, and 1-butene·α-olefin copolymer are preferable, and one kind or two or more kinds selected from polyethylene, polypropylene, poly-1-butene, poly-4-methyl-1-pentene, ethylene·α-olefin copolymer, propylene·α-olefin copolymer, 1-butene·α-olefin copolymer, ethylene·vinyl acetate copolymer, polyether block amide, ionomer, fluorine-based resin, acid-modified fluorine-based resin, rosin-based resin, terpene-based resin, petroleum resin, and styrene-based elastomer, the addition of which improve melt tension are more preferable.

Further, those having an appropriate compatibility with the 4-methyl-1-pentene-based polymer (a1) in the present disclosure are more preferable. Further, among styrene-based elastomers, vinyl SIS (product name: HYBRAR, brand: 5127) and vinyl SEPS (product name: HYBRAR, brand: 7125) manufactured by Kuraray Co., Ltd., and SEBS (product name: S.O.E, brand: S1605, S1611, and L609) manufactured by Asahi Kasei Corporation can be preferably used, from a viewpoint of compatibility, a temperature range showing the local maximum value of the loss tangent, and a magnitude of the local maximum value of the loss tangent.

For the self-adhesive member in the present disclosure, one kind selected from these modified resins (a2) can be used alone or two or more kinds thereof can be used in combination.

The content of the modified resin (a2) in the self-adhesive member in the present disclosure is not particularly limited, but when the entire content of the self-adhesive member is 100% by mass, the content of the modified resin (a2) is preferably 0.5% by mass or more, more preferably 1% by mass or more, even more preferably 2% by mass or more, still even more preferably 3% by mass or more, and preferably 50% by mass or less, more preferably 40% by mass or less, even more preferably 35% by mass or less, still even more preferably 30% by mass or less, and particularly preferably 25% by mass or less.

When the content of the modified resin (a2) is the lower limit value or more, it is possible to further improve appearance, texture, fixability, and the like of the self-adhesive member in the present disclosure. When the content of the modified resin (a2) is the upper limit value or less, it is possible to further improve performance balance between the fixability and flexibility of the self-adhesive member in the present disclosure.

[Other Components]

The self-adhesive member in the present disclosure may be mixed with additives such as a heat stabilizer, an antioxidant, an ultraviolet absorber, a pigment, an antistatic agent, a copper inhibitor, a flame retardant, a neutralizing agent, a plasticizer, a nucleating agent, a weather stabilizer, a light stabilizer, an anti-aging agent, a fatty acid metal salt, a softener, a dispersant, a coloring agent, a lubricant, a natural oil, a synthetic oil, a wax, and the like, depending on the necessity. Among these, in particular, the plasticizer, the softener, the natural oil, and the synthetic oil may be used by controlling the kind and the addition amount in order to adjust a temperature showing a local maximum value of the loss tangent (tan δ) of solid viscoelasticity and the local maximum value of the loss tangent of the self-adhesive member in the present disclosure.

The resin composition containing the 4-methyl-1-pentene-based polymer (a1) can be prepared by mixing or melting and kneading each component by a dry blend, a tumbler mixer, a Banbury mixer, a single screw extruder, a twin screw extruder, a high-speed twin screw extruder, a hot roll, and the like.

In addition, the self-adhesive member in the present disclosure may be formed of a single layer or a multilayer. In a case of a multilayer, at least one layer is required to be a layer containing the 4-methyl-1-pentene-based polymer (a1), and two or more layers may contain the 4-methyl-1-pentene-based polymer (a1).

[Surface Roughness]

The self-adhesive member in the present disclosure preferably has an arithmetic average roughness Ra of the self-adhesive surface of 0.01 um to 10 um from the viewpoint of good fixability.

The arithmetic average roughness Ra of the self-adhesive surface is more preferably 0.02 um to 8 um, and even more preferably 0.03 um to 5 um.

In the self-adhesive member in the present disclosure, from the viewpoint of good fixability, the ten-point average roughness Rz of the self-adhesive surface is preferably 0.1 um to 50 um, more preferably 0.2 um to 40 um, and even more preferably 0.3 um to 20 um.

In the present disclosure, by controlling the arithmetic average roughness Ra and the ten-point average roughness Rz in combination, the variation in unevenness can be effectively suppressed and more uniform fixing power can be obtained on the entire surface of the self-adhesive member.

The self-adhesive member in the present disclosure preferably has an arithmetic average roughness Ra of the self-adhesive surface in a range of 0.01 um to 10 um and a ten-point average roughness Rz of 0.1 um to 50 um.

The method for adjusting the surface roughness of the self-adhesive surface in the present disclosure is not particularly limited, and a known method can be used. For example, the adjustment may be performed by a method by mold molding such as embossing in a sheet production process, a method for transferring the surface shape of an interleaving paper (separator) by interposing the interleaving paper between sheets when winding up the sheet, polishing, and a blasting treatment, and the like.

The arithmetic average roughness Ra and the ten-point average roughness Rz are measured according to JIS B 0610-2001.

Specifically, according to JIS B 0610-2001, a surface roughness shape measuring machine (for example, SURFCOM 1400D, manufactured by Tokyo Seimitsu Co., Ltd.) is used to measure the arithmetic average roughness Ra and the ten-point average roughness Rz of the surface of the self-adhesive member at a measurement length of 40 mm and a measurement speed of 0.15 mm/sec. This measurement is performed three times, and the average values thereof are taken as the arithmetic average roughness Ra (um) and the ten-point average roughness Rz ($\mu$m).

[Thickness]

The thickness of the self-adhesive member in the present disclosure is not particularly limited, but is preferably in a range of 0.01 mm or more and 30 mm or less, more preferably in a range of 0.01 mm or more and 10 mm or less, and even more preferably in a range of 0.02 mm or more and 5 mm or less, and particularly preferably in a range of 0.03 mm or more and 2 mm or less.

By setting the thickness of the self-adhesive member in the present disclosure to the above lower limit value or more, a good balance between shape followability, mechanical properties, moldability, moisture resistance, and the like can be obtained while improving fixability.

By setting the thickness of the self-adhesive member in the present disclosure to the above upper limit value or less, it is possible to improve lightness, appearance, and handleability while maintaining good fixability.

The shape of the self-adhesive member in the present disclosure is not particularly limited, but is preferably a sheet-like shape.

The self-adhesive member in the present disclosure may have a ventilation hole in order to enhance air permeability depending on the application. For example, by using processing techniques such as mechanical punching, needle processing, laser perforation, and water jet, a large number of ventilation holes communicating with each other can be provided on the front and back sides.

[Density]

The density of the self-adhesive member in the present disclosure measured according to ASTM D 1505 (underwater substitution method) is preferably 0.3 to 1.5 g/cm$^3$, more preferably 0.5 to 1.2 g/cm$^3$, even more preferably 0.8 to 0.9 g/cm$^3$, and particularly preferably 0.83 to 0.85 g/cm$^3$.

The density of the self-adhesive member is the density measured according to ASTM D 1505 (underwater substitution method).

Specifically, the density was calculated from the weight of each sample measured in water and air using, for example, an electronic hydrometer MD-300S manufactured by ALFA MIRAGE Co., Ltd. according to ASTM D 1505 (underwater substitution method).

[Transparency]

When the self-adhesive member in the present disclosure is applied to application for transparency, for example, it is preferable that the internal haze with respect to visible light (hereinafter, also simply referred to as "internal haze") is 30% or less.

Here, the "internal haze" refers to a haze excluding the haze due to the shape of the outer surface of the self-adhesive member. In addition, the "internal haze" is a value measured at 25°C for the self-adhesive member according to JIS-K 7105.

The internal haze of the self-adhesive member in the present disclosure is preferably 30% or less, more preferably 20% or less, even more preferably 13% or less, particularly preferably 5% or less, still even more preferably 2.0% or less, and yet still even more preferably 1.0% or less.

On the other hand, the lower the internal haze of the self-adhesive member in the present disclosure is, the better it is, from the viewpoint of transparency, but from the viewpoint of balance with adhesiveness and the like, the lower limit value thereof is preferably 0.01% or more.

That is, the transparency of the self-adhesive member in the present disclosure can be evaluated by the internal haze.

In addition, the transparency of the self-adhesive member in the present disclosure may be evaluated not only by the above-mentioned internal haze but also by the internal light transmittance.

Here, the "internal light transmittance" refers to a light transmittance excluding the influence of the shape of the outer surface of the self-adhesive member.

The internal light transmittance of the self-adhesive member in the present disclosure is preferably 90.0% or more, more preferably 95.0% or more, even more preferably 97.0% or more, particularly preferably 98.0% or more, still even more preferably 99.0% or more, and ideally 100%.

Specifically, the internal haze and the internal light transmittance of the self-adhesive member in the present disclosure can be measured as follows.

-Internal Haze-

The internal haze of the self-adhesive member in the present disclosure (hereinafter, also referred to as internal haze (H1)) is obtained by the following method.

First, a haze (H2) (%) was measured by sandwiching only silicone oil (SHIN-ETSU SILICONE (trademark), model number: KF96-100CS, manufactured by Shin-Etsu Chemical Co., Ltd.) between two glass plates in advance. Next, the haze (H3) (%) is measured by sandwiching the self-adhesive member whose surface is uniformly coated with silicone oil between the two glass plates.

Next, the internal haze (H1) (%) of the self-adhesive member is obtained by taking a difference between the obtained values as in the following expression (1).

$$\text{Internal haze (H1)} = \text{haze (H3)} - \text{haze (H2)} \quad (1)$$

It should be noted that the haze (H2) and the haze (H3) (both have a unit of %) are measured using the following apparatus under the following measurement conditions.

Measuring apparatus: HAZE METER TC-HIIIDPK manufactured by Tokyo Denshoku Co., Ltd.

Sample size: 30 mm in width × 30 mm in length
Measurement conditions: compliant with JIS-K 7136 (2000)
Measurement temperature: room temperature (25°C)

-Internal Light Transmittance-

During the measurement of the internal haze of the self-adhesive member in the present disclosure, a light transmittance (T2) (%) is measured instead of the haze (H2) in the measurement of the haze (H2), and a light transmittance (T3) (%) is measured instead of the haze (H3) in the measurement of the haze (H3). Next, an internal light transmittance (T1) (%) of the self-adhesive member is obtained by the following expression (2).

$$\text{Internal light transmittance (T1)} = 100 - (\text{light transmittance}$$
$$(\text{T2}) - \text{light transmittance (T3)}) \quad (2)$$

<Release Film>

It is preferable that the sealing member of the present disclosure further includes a release film arranged between the self-adhesive surfaces.

With this, it is possible to prevent the self-adhesive surfaces from adhering to each other until a desired time.

That is, the sealing member of the present disclosure can include a release film arranged between the self-adhesive surfaces facing each other.

Examples of the release film include an oriented polystyrene film (OPS), an oriented polypropylene film (OPP), a polyethylene terephthalate film (PET), and the like.

There is no particular limitation on the method for producing the sealing member including the release film.

For example, when the opening and closing portion is produced by overlapping the self-adhesive members after processing, the release film may be interposed between the self-adhesive surfaces in advance.

The sealing member of the present disclosure can be attached to another material (for example, a packaging material described later).

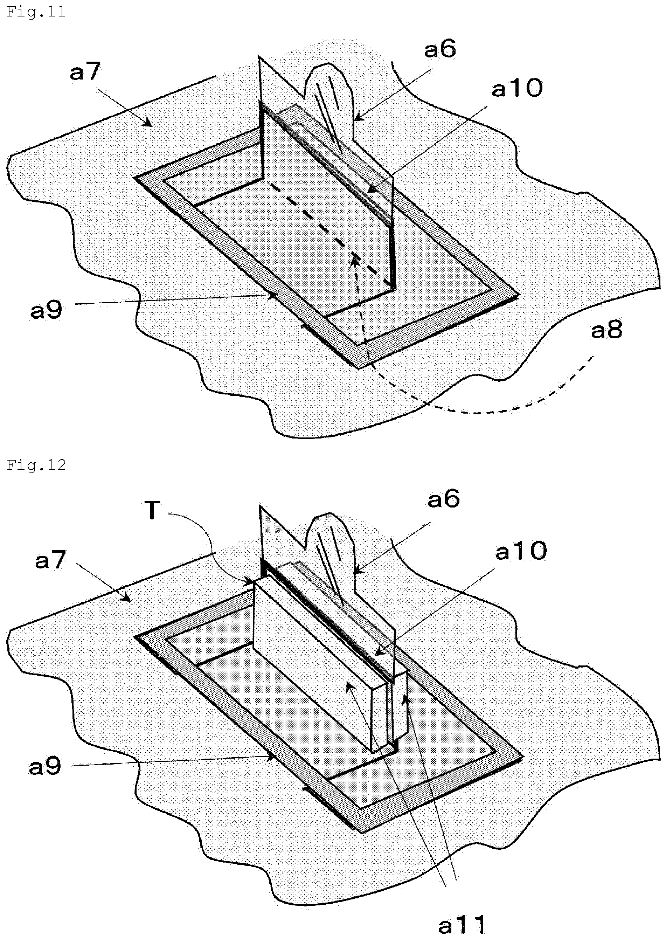

Fig. 11 is a schematic view showing an embodiment of the sealing member of the present disclosure attached to another material.

As shown in Fig. 11, before attaching the sealing member including a release film a6 to an opening and closing portion a10, first, a packaging material a7 is provided with a hole a8 passing through the opening and closing portion a10 of the sealing member.

Next, the opening and closing portion a10 passes through the hole a8. Then, the outer peripheral portion of the hole a8 is heat-sealed so that the packaging material a7 and the sealing member are integrated, and a heat-sealed portion a9 is provided.

<Resin Plate>

It is preferable that the sealing member of the present disclosure further includes a resin plate disposed on a side opposite to the self-adhesive surface with respect to the self-adhesive member, and the resin plate satisfies the following Requirements 2 to 4.

(Requirement 2) The resin plate has a bending elastic modulus of 500 MPa to 2500 MPa (JIS K 7171).

(Requirement 3) The resin plate has a thickness of 500 um to 3000 um.

(Requirement 4) The resin plate has hinge structures at both ends.

When the sealing member of the present disclosure includes the resin plate in the present disclosure, opening and closing of the opening and closing portion can be easily performed.

Since the sealing member of the present disclosure includes the resin plate in the present disclosure, the airtightness of the opening and closing portion can be satisfactorily maintained due to the rigidity of the resin plate itself.

The resin plate preferably has a bending elastic modulus of 500 MPa to 2500 MPa measured according to JIS K7171 (2016).

When the bending elastic modulus is 500 MPa or more, a certain degree of rigidity can be given to the resin plate, so that the self-adhesive member can be more firmly interposed and the opening and closing portion can be satisfactorily fixed.

On the other hand, when the bending elastic modulus is 2500 MPa or less, a certain degree of flexibility can be given to the resin plate, so that the opening and closing of the opening and closing portion can be satisfactorily operated.

From the above viewpoint, the bending elastic modulus of the resin plate measured according to JIS K 7171 (2016) is more preferably 800 MPa to 2300 MPa, and even more preferably 800 MPa to 1500 MPa.

The resin plate has a thickness of 500 um to 3000 um.

With this, the opening and closing portion can be easily opened and closed.

From the above viewpoint, the thickness of the resin plate is preferably 1000 um to 2000 um.

The resin plate has a hinge structure at both ends.

Since the resin plate satisfies the requirements 2 and 3 and further has a hinge structure at both ends, the resin plate can be easily curved, so that the handleability can be improved.

The sealing member of the present disclosure preferably includes a pair of resin plates disposed on the side opposite to the self-adhesive surface with respect to the self-adhesive member.

The method for forming the hinge structure is not particularly limited.

For example, both ends of the resin plate may be heat-sealed to form a hinge structure.

The material of the resin plate is not particularly limited.

Examples of the material of the resin plate include rigid vinyl chloride (PVC), high-density polyethylene (HDPE), polypropylene (PP), polycarbonate (PC), polystyrene (ABS), and the like.

The resin plate may be a plate formed of various thermoplastic resins, may be a foam obtained by foaming a resin, or may be a laminate of several kinds of resins.

<Cushioning Material>

It is preferable that the sealing member of the present disclosure further includes a cushioning material provided between the self-adhesive member and the resin plate.

As a result, when pressure is applied to the resin plates to bring the self-adhesive members into close contact with each other, the adhesion of the opening and closing portion can be further improved, and thus the airtightness of the opening and closing portion can be improved.

For example, when the penetration member having a certain thickness is interposed in the opening and closing portion, it is preferable to include a cushioning material between the self-adhesive member and the resin plate. With this, when pressure is applied to the resin plates to bring the self-adhesive members into close contact with each other, the adhesion of the self-adhesive surface and the penetration member can also be improved as well as the adhesion of the opening and closing portion.

As a result, the airtightness of the opening and closing portion is excellent in a state in which a penetration member such as a tube is fixed to the opening and closing portion, and the airtightness of the opening and closing portion is excellent in a state in which other members such as a penetration member are not fixed to the opening and closing portion.

The penetration member penetrating the opening and closing portion is not particularly limited.

For example, for the sealing members of the present disclosure, it is preferable that at least one selected from the group consisting of a tube, a catheter, a cable and a wire penetrates the opening and closing portion.

Among these, as the sealing members of the present disclosure, it is preferable that at least one selected from the group consisting of a tube, a catheter, a power cable, a communication cable, and a wire penetrate the opening and closing portion.

The thickness of the cushioning material is not particularly limited.

For example, when the penetration member having a certain thickness is interposed in the opening and closing portion, the thickness may be appropriately set according to the thickness of the penetration member.

The thickness of the cushioning material may be 5 mm to 20 mm, 7 mm to 15 mm, or 9 mm to 13 mm.

The cushioning material is not particularly limited as long as the material can further improve the adhesion of the opening and closing portion when the self-adhesive member is brought into close contact with the resin plate by applying pressure.

For example, a resin such as polyethylene may be used, and high-pressure low-density polyethylene (also referred to as LLDPE) is preferable.

Further, the cushioning material is preferably a foam.

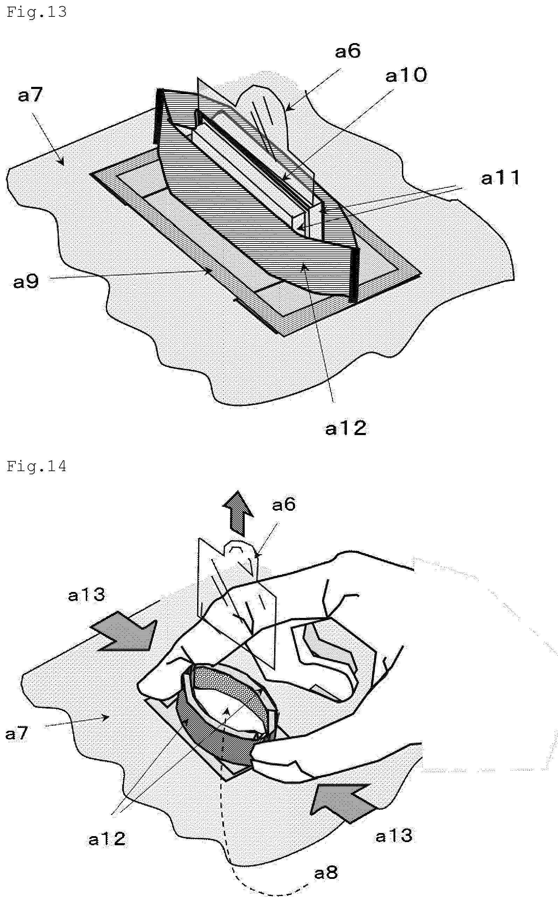

Aspects of the resin plate and the cushioning material in the sealing member of the present disclosure will be described with reference to Figs. 12 and 13.

Fig. 12 is a schematic view showing a sealing member including a cushioning material.

In Fig. 12, the sealing member having a thickness t includes an opening and closing portion a10 surrounded by a pair of cushioning materials a11 having a thickness T, and a release film a6 between the self-adhesive surfaces facing each other.

That is, the cushioning material a11 is included on the side opposite to the self-adhesive surface of the self-adhesive member.

With this, for example, in a case where the penetration member having a certain thickness is interposed in the opening and closing portion, the member volume of the penetration member can be absorbed.

A heat-sealed portion a9 is formed by heat-sealing the sealing member and the packaging material a7 so as to be integrated with each other.

The sealing member including the resin plate and the cushioning material will be described with reference to Fig. 13.

Fig. 13 is a schematic view showing the sealing member including the resin plate and the cushioning material.

As shown in Fig. 13, the sealing member includes a pair of self-adhesive members, an opening and closing portion a10 surrounded by the self-adhesive members, and a release film a6 between the facing self-adhesive surfaces.

In addition, the sealing member includes a resin plate a12 disposed on the side opposite to the self-adhesive surface, and includes a cushioning material a11 between the self-adhesive member and the resin plate a12.

A heat-sealed portion a9 is formed by heat-sealing the sealing member and the packaging material a7 so as to be integrated with each other.

Subsequently, in the sealing member of the present disclosure, an embodiment of a method for passing the penetration member through the opening and closing portion will be described with reference to Figs. 14 to 17.

Fig. 14 is a schematic view showing a method for opening the opening and closing portion by separating the self-adhesive surfaces from each other.

As shown in Fig 14, in the sealing member attached to the predetermined position of the packaging material a7, the hinge structures at both ends of the resin plate a12 are manually squeezed in a direction a13 in which the resin plates are separated from each other, and addition is applied to provide a hole a8 between the resin plates. In a state in which the hole a8 is provided, the release film a6 is pulled in the direction of the arrow.

At this time, the self-adhesive surfaces are in a separated state, and the opening and closing portion is opened.

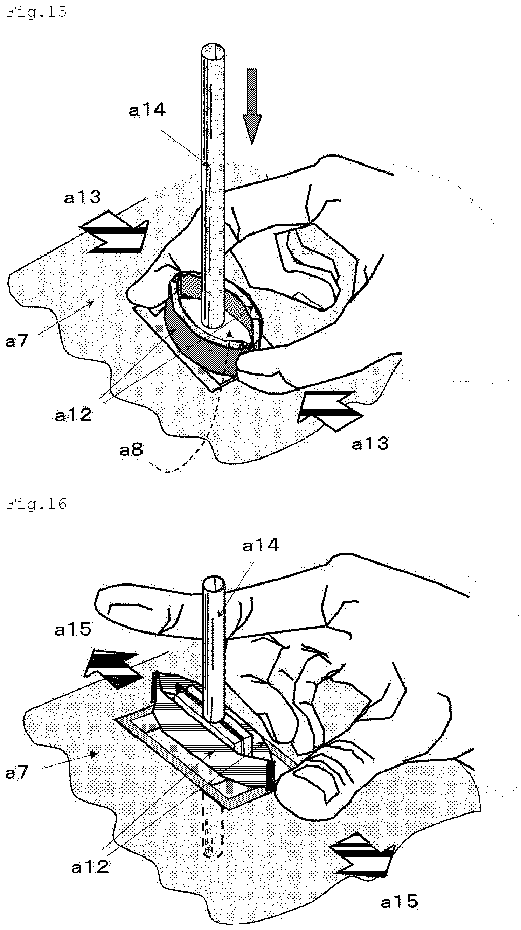

Fig. 15 is a schematic view showing a method for causing the penetration member to penetrate the opening and closing portion.

The penetration member a14 is passed through the hole a8 and inserted to a certain position. With this, the penetration member a14 can be caused to penetrate the opening and closing portion.

From the viewpoint of airtightness, it is preferable to remove garbage, dust, moisture, oil, and the like from the penetration member in advance before performing the penetration.

Fig. 16 is a schematic view showing a method for closing the opening and closing portion with the penetration member interposed therebetween.

After the penetration of the penetration member a14, the manually applied addition is released in a direction a15 for closing the resin plates, and the penetration member a14 is interposed between the resin plates a12.

At this time, the opening and closing portion is closed in a state in which the penetration member a14 penetrates the opening and closing portion.

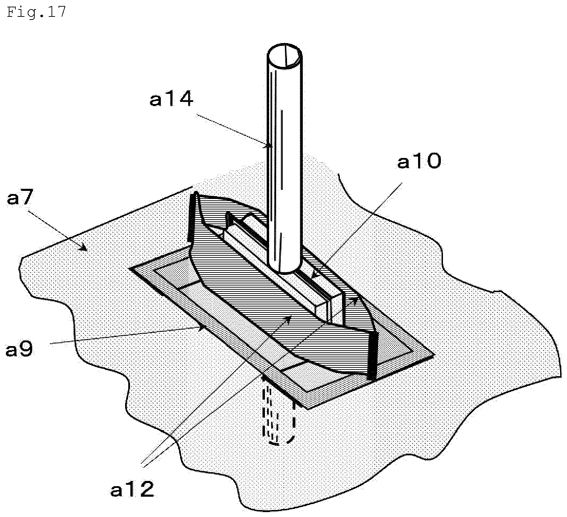

Fig. 17 is a schematic view showing a method for maintaining a close contact state of the opening and closing portion with the penetration member interposed therebetween.

By storing the sealing member including the opening and closing portion a10 with the penetration member a14 interposed therebetween at a predetermined temperature (for example, 25°C or lower), a state of close contact between the self-adhesive surfaces, and between the self-adhesive surfaces and the penetration member a14 can be maintained.

In a case where the penetration member (a14) is removed, changed, or the like, the removal, change, or the like may be performed according to the above-mentioned item relating to Fig. 15 and the item relating to Fig. 16.

<Method for Producing Self-Adhesive Member>

The self-adhesive member in the present disclosure is, for example, by molding a resin composition containing a 4-methyl-1-pentene-based polymer (a1) or the 4-methyl-1-pentene-based polymer (a1) into a sheet shape.

The molding apparatus and the molding conditions are not particularly limited, and a conventionally known molding apparatus and molding conditions can be employed. For example, known methods such as extrusion molding, inflation molding, and calendaring molding, or the like can be applied. Among these, it is preferable to perform molding by an extrusion molding apparatus. In addition, even in a case where the self-adhesive member has a multilayer structure, known methods such as coextrusion (extrusion using a multi-die) and various lamination methods can be appropriately applied.

<<Packaging Member>>

The packaging member of the present disclosure includes the sealing member of the present disclosure and a packaging material.

The sealing member of the present disclosure has excellent airtightness of the opening and closing portion in an environment close to normal temperature, and therefore has high airtightness in the internal region to be sealed.

Therefore, by providing the above-mentioned configuration, the packaging member of the present disclosure can store an object to be packaged in an environment in which the growth of bacteria is suppressed.

The packaging material is not particularly limited.

As the packaging material, a commercially available product may be used, and for example, a TEDLAR (registered trademark) bag may be used.

[Application]

The sealing member and the packaging member of the present disclosure can be used to repeatedly open and close the opening and closing portion.

Therefore, the sealing member and the packaging member can be widely applied to application for repeatedly opening and closing or attaching and detaching the opening and closing portion, and can be used in various industrial fields such as food, clothing, medical supplies, nursing care supplies, housing equipment, automobiles and aircrafts, and the like.

The sealing member of the present disclosure has excellent airtightness of the opening and closing portion in an environment close to normal temperature, and therefore has high airtightness in the internal region to be sealed. As a result, for example, it is possible to suppress the growth of bacteria in the sealed internal region.

Therefore, the sealing member of the present disclosure is preferably used for accommodating humans, animals, foods, pharmaceuticals, or cosmetics.

Although the embodiments of the present invention have been described above, these are examples of the present invention, and various configurations other than the above can be adopted. In addition, the present invention is not limited to the above-described embodiments, and modifications, improvements, and the like within a range in which the object of the present invention can be achieved are included in the present invention.

[Examples]

Hereinafter, the embodiments will be described in detail with reference to Examples and Comparative Examples. The present embodiment is not limited to the descriptions of these examples.

<Measuring Method>

(1) Dynamic Viscoelasticity Measurement of Sheet

The self-adhesive sheet was cut into a strip having a size of 50 mm in length $\times$ 5 mm in width to form a test piece. Next, for the obtained test piece, using RSAIII manufactured by TA Instruments Co., Ltd., temperature dependence of dynamic viscoelasticity was measured under the conditions of a temperature range of 0°C to 110°C, a chuck-to-chuck distance of 20 mm, a frequency of 1.59 Hz, a strain amount of 0.1%, a temperature rising rate of 4 °C/min, and a tensile mode. From the obtained graph, the temperature showing the local maximum value of the loss tangent (tan $\delta$) and the local maximum value of the tan $\delta$ were obtained respectively.

(2) Intrinsic Viscosity [$\eta$] of 4-Methyl-1-Pentene-Based Polymer

The intrinsic viscosity [$\eta$] was measured at 135°C using a decalin solvent.

(3) Composition of 4-Methyl-1-Pentene-Based Polymer

The contents of 4-methyl-1-pentene and $\alpha$-olefin in the 4-methyl-1-pentene-based polymer were quantitatively determined by $^{13}C$-NMR.

(4) Density of Sheet

The density was calculated from the weight of each sample measured in water and air using an electronic hydrometer MD-300S manufactured by ALFA MIRAGE Co., Ltd. according to ASTM D 1505 (underwater substitution method).

(5) Surface Roughness of Sheet

According to JIS B0610-2001, a surface roughness shape measuring machine (for example, SURFCOM 1400D, manufactured by Tokyo Seimitsu Co., Ltd.) was used to measure the arithmetic average roughness Ra and the ten-point average roughness Rz of the surface of the self-adhesive sheet at a measurement length of 40 mm and a measurement speed of 0.15 mm/sec. The measurement was performed three times, and the average values thereof were taken as the arithmetic average roughness Ra (um) and the ten-point average roughness Rz ($\mu$m).

[Experiment 1]

<Materials>

The materials used in Examples and Comparative Examples are shown below.

(1) 4-Methyl-1-pentene-based polymer: copolymer of 4-methyl-1-pentene and propylene (content of constitutional unit derived from 4-methyl-1-pentene: 72 mol%, content of constitutional unit derived from propylene: 28 mol%)

- Glass transition temperature: 30°C
- Intrinsic viscosity in decalin at 135°C [$\eta$]: 1.5 dL/g
- MFR: 28 g/10 min

(2) Foaming agent: sodium hydrogen carbonate-based chemical foaming agent

<Preparation of Sheet Containing 4-Methyl-1-Pentene-Based Polymer>

[Example 1A]

As the molding machine, an apparatus including a single-screw extrusion molding machine (cylinder inner diameter D: 65 mm, full flight screw), a T-die (die width: 750 mm), a cooling roll, and a take-off machine was used.
First, the 4-methyl-1-pentene-based polymer was put into the extrusion molding machine, melted and kneaded under the conditions of a temperature of 100°C to 250°C at each part of the cylinder and a screw rotation speed of 23 rpm, and extruded from the T-die such that the extrusion amount was 15 kg/hour.

The extruded sheet was cooled with the cooling roll (temperature of water flowing in the roll: 20°C), and taken off by using the take-off machine (take-off rate: 1.3 m/min) to obtain a 4-methyl-1-pentene-based polymer sheet having a sheet thickness of 0.3 mm and sheet width of about 700 mm.

An unevenness-processed interleaving paper was pressed against the surface of the obtained sheet to transfer the unevenness, and the surface roughness of the sheet was adjusted.

[Example 2A]

As the molding machine, an apparatus including a single-screw extrusion molding machine (cylinder inner diameter D: 65 mm, full flight screw), a T-die (die width: 750 mm), a cooling roll, and a take-off machine was used.

First, the 4-methyl-1-pentene-based polymer was put into the extrusion molding machine, melted and kneaded under the conditions of a temperature of 100°C to 250°C at each part of the cylinder and a screw rotation speed of 50 rpm, and extruded from the T-die such that the extrusion amount was 23 kg/hour.

The extruded sheet was cooled with the cooling roll (temperature of water flowing in the roll: 10°C), and taken off by using the take-off machine (take-off rate: 1.0 m/min) to obtain a 4-methyl-1-pentene-based polymer sheet having a sheet thickness of 0.6 mm and sheet width of about 700 mm.

An unevenness-processed interleaving paper was pressed against the surface of the obtained sheet to transfer the unevenness, and the surface roughness of the sheet was adjusted.

[Comparative Example 1A]

As the molding machine, an apparatus including a single-screw extrusion molding machine (cylinder inner diameter D: 65 mm, full flight screw), a T-die (die width: 750 mm), a cooling roll, and a take-off machine was used.

First, 97 wt% of the 4-methyl-1-pentene-based polymer and 3 wt% of a sodium hydrogen carbonate-based chemical foaming agent were put into the extrusion molding machine and (each component raw material was) melted and kneaded under the conditions of a temperature of 100°C to 220°C at each part of the cylinder and a screw rotation speed of 20 rpm, and the mixture was extruded from the T-die such that the extrusion amount was 13 kg/hour.

The extruded sheet was cooled with the cooling roll (temperature of water flowing in the roll: 20°C), and taken off by using the take-off machine (take-off rate: 1.3 m/min) to obtain a 4-methyl-1-pentene-based polymer foam sheet having a sheet thickness of 0.5 mm and sheet width of about 700 mm.

[Comparative Example 2A]

As the molding machine, an apparatus including a single-screw extrusion molding machine (cylinder inner diameter D: 50 mm, full flight screw), a T-die (die width: 320 mm), a cooling roll, and take-off machine was used.

First, 97 wt% of the 4-methyl-1-pentene-based polymer and 3 wt% of a sodium hydrogen carbonate-based chemical foaming agent were put into the extrusion molding machine and (each component raw material was) melted and kneaded under the conditions of a temperature of 100°C to 220°C at each part of the cylinder and a screw rotation speed of 10 rpm, and the mixture was extruded from the T-die such that the extrusion amount was 3 kg/hour.

The extruded sheet was cooled with the cooling roll (temperature of water flowing in the roll: 25°C), and taken off by using the take-off machine (take-off rate: 0.6 m/min) to obtain a 4-methyl-1-pentene-based polymer foam sheet having a sheet thickness of 0.5 mm and sheet width of about 280 mm.

<Evaluation>

The following evaluation was performed using each of the obtained sheets. The results are shown in Table 1.

· Maximum shear rate and elongation (%)

The sheet was cut into a strip having a size of 85 mm in length × 20 mm in width to form a test piece. In an environment of a temperature of 23°C and a relative humidity of 50%, two test pieces were overlapped with each other so that the surfaces having surface roughness shown in Table 1 faced each other with an attachment size of 20 mm in width and 25 mm in length, and pressure was applied to the test pieces at 0.026 MPa for 1 second using a heat sealer (TP701B, manufactured by Tester Sangyo Co. Ltd.) set to 40°C. Then, the test pieces were left to stand for 24 hours in an environment of a temperature of 23°C and a relative humidity of 50%.

Next, a tensile test was performed using a tensile tester (AG-X-5 manufactured by Shimadzu Corporation) at a chuck-to-chuck distance of 50 mm and a tension rate of 50 mm/min, and the maximum shear stress (MPa) and the elongation (%) at the time of pulling were measured. This measurement was performed 5 times, and the average values thereof were taken as the maximum shear stress (MPa) and elongation (%).

[Table 1]

|  |  | Example 1A | Example 2A | Comparative Example 1A | Comparative Example 2A |
|---|---|---|---|---|---|
| Sheet | Density (g/cm³) | 0.84 | 0.84 | 0.58 | 0.66 |
|  | Thickness (mm) | 0.3 | 0.6 | 0.5 | 0.5 |
|  | tan $\delta$ local maximum value temperature (°C) | 30 | 30 | 30 | 30 |
|  | tan $\delta$ local maximum value | 2.67 | 2.63 | 2.45 | 2.63 |
|  | Arithmetic average roughness Ra (um) | 0.05 | 0.07 | 11.98 | 12.29 |
|  | Ten-point average roughness Rz (um) | 0.6 | 0.41 | 64.55 | 57.9 |
| Evaluation | Maximum shear stress (MPa) | 7.7 | 7 | 1.4 | 1.6 |
|  | Elongation (%) | 155 | 141 | 28 | 63 |

[Experiment 2]

<Evaluation>

When each sheet of Examples 1A and 2A obtained in Experiment 1 above was attached to the skin (upper arm) of an adult male, each sheet was satisfactorily brought into close contact with the skin, and was not detached even when the upper arm was turned.

[Experiment 3]

<Measuring Method>

(Dynamic Viscoelasticity Measurement)

The self-adhesive member was cut into a strip having a size of 50 mm in length $\times$ 5 mm in width to form a test piece. Next, for the obtained test piece, using RSAIII manufactured by TA Instruments Co., Ltd., temperature dependence of dynamic viscoelasticity was measured under the conditions of a temperature range of 0°C to 110°C, a chuck-to-chuck distance of 20 mm, a frequency of 1.59 Hz, a strain amount of 0.1%, a temperature rising rate of 4 °C/min, and a tensile mode. From the obtained graph, the temperature showing the local maximum value of the loss tangent (tan $\delta$) and the local maximum value of the tan $\delta$ were obtained respectively.

(Composition of 4-Methyl-1-Pentene-Based Polymer)

The contents of 4-methyl-1-pentene and $\alpha$-olefin in the 4-methyl-1-pentene-based polymer were quantitatively determined by $^{13}$C-NMR.

<Materials>

The materials used in Examples and Comparative Examples are shown below.

· Foaming agent: sodium hydrogen carbonate-based chemical foaming agent
· Packaging material: gas barrier test bag "TEDLAR BAG" with a capacity of 1 L (manufactured by GL Sciences Co., Ltd.)

In the TEDLAR BAG, 6 $\varphi$ pinchcocks are attached at two places.

[Example 1C]

<4-Methyl-1-Pentene-Based Polymer>

In Example 1, the following 4-methyl-1-pentene-based polymer was used.

· 4-Methyl-1-pentene-based polymer: copolymer of 4-methyl-1-pentene and propylene (content of constitutional unit derived from 4-methyl-1-pentene: 72 mol%, content of constitutional unit derived from propylene: 28 mol%)

Temperature showing local maximum value of loss tangent (tan $\delta$) : 30°C

Local maximum value of loss tangent (tan $\delta$): 2.7
Glass transition temperature: 30°C
Intrinsic viscosity in decalin at 135°C [$\eta$]: 1.5 dL/g
MFR: 28 g/10 min

<Preparation of Self-Adhesive Member Containing 4-Methyl-1-Pentene (4-MP)-Based Polymer>

As the molding machine, an apparatus including a single-screw extrusion molding machine (cylinder inner diameter D: 65 mm, full flight screw), a T-die (die width: 750 mm), a cooling roll, and a take-off machine was used, and as the material, a 4-methyl-1-pentene-based polymer was used to obtain a self-adhesive member having the thickness, width, and length shown in Table 1.
The unevenness-processed interleaving paper was pressed against the self-adhesive surface of the obtained self-adhesive member to transfer the unevenness, and the surface roughness of the self-adhesive surface was adjusted.

<Preparation of Packaging Member Including Sealing Member>

A method for preparing the packaging member including the sealing member in the present embodiment will be described.
First, two self-adhesive members were processed and overlapped with each other to prepare an opening and closing portion having a width of 15 mm and a length l of 40 mm. In addition, a release film (polyethylene terephthalate (PET) film having a thickness of 50 um) was interposed between the self-adhesive surfaces in the opening and closing portion. A polyethylene terephthalate (PET) film having a thickness of 50 um was interposed in the opening and closing portion.
Next, a hole was formed by making a notch in one place on the surface of a gas barrier test bag "TEDLAR BAG" with a capacity of 1 L (manufactured by GL Sciences Co., Ltd.), as a packaging material, so as to have the same length as the opening and closing portion.
The opening and closing portion was passed through the hole so that the side in the length direction of the opening and closing portion coincided with the hole. Then, when heat-sealing the outer peripheral portion of the hole to provide a heat-sealed portion, the opening portion and the packaging material were connected to obtain a sealing member.
Then, the sealing member was heated to 40°C to 45°C to improve the adhesiveness and flexibility, and the opening and closing portion was opened to remove the release film. Then, a "SILICON TUBE" (manufactured by Laboran Silicone Tube Co., Ltd., penetration member) having an outer diameter of 4 $\varphi$, and having one side sealed, was interposed in the opening and closing portion and the opening and closing portion was manually closed.
From the above, a packaging member including a sealing member was prepared.

[Example 2C to Example 8C, and Comparative Example 1C to Comparative Example 4C]

Examples 2C to 8C and Comparative Examples 1C to 4C were carried out in the same manner as in Example 1C except for the following points .
In Examples 2C to 8C and Comparative Examples 1C to 4C, the thickness, the width and the length of the self-adhesive member were changed as shown in Table 2, and the kind and the outer diameter of the penetration member were changed as shown in Table 2.
In Examples 2C to 8C and Comparative Examples 1C to 4C, a cushioning material having the material, the expansion ratio, and the thickness shown in Table 2 was formed on the sealing member.
In Examples 2C to 8C and Comparative Examples 1C to 4C, a resin plate having hinge structures at both ends with respect to the sealing member and having the material, the thickness, the length, and the bending elastic modulus shown in Table 2 was formed.

In Examples 7C and 8C, the kind of polymer was changed to 4-MP having a temperature showing the local maximum value of the loss tangent (tan $\delta$) and the local maximum value of the loss tangent (tan $\delta$) shown in Table 2.

In Comparative Example 1C to Comparative Example 4C, the kind of polymer was changed to polypropylene (PP, manufactured by Prime Polymer Co., Ltd.) having a temperature showing the local maximum value of the loss tangent (tan $\delta$) and the local maximum value of the loss tangent (tan $\delta$) shown in Table 1.

In addition, in Table 2, the mark "-" means that the composition, the numerical value or the component corresponding to the item is not included.

For example, the mark"-" in the items of "Cushioning material", "Resin plate" and "penetration member" means that the sealing member does not include "Cushioning material", "Resin plate" and "penetration member".

In Table 2, "Expanded 5 times" means a polypropylene plate expanded 5 times ("PAULOWNIA Super", manufactured by Mitsui Chemicals Tohcello Inc.).

In Table 2, the term "PET" means a polyethylene terephthalate (PET) plate (a laminate in which three PET films (manufactured by Teijin Limited) having a thickness of 0.2 mm are laminated).

In Table 2, the term "LDPE" means low-density polyethylene.

In Table 2, the term "HDPE" means high-density polyethylene.

In Table 2, the term "ABS" means polystyrene.

[Reference Example]

The packaging material according to Reference Example does not include a sealing member. That is, the packaging material "TEDLAR BAG" itself is used as a packaging member.

<Evaluation>

(Self-Adhesiveness)

Pressure was applied to the surfaces of the self-adhesive members containing the 4-methyl-1-pentene (4-MP)-based polymer obtained in Examples 1C to 8C at 0.026 MPa for 1 second using a heat sealer (TP701B, manufactured by Tester Sangyo Co. Ltd.) set to 40°C and the self-adhesive members were left to stand for 24 hours in the environment at a temperature of 23°C and a relative humidity of 50%. Then, when a tensile test (chuck-to-chuck distance: 50 mm, tension rate: 50 mm/min) was performed, the maximum shear stress (MPa) was 2.0 MPa or more.

(Airtightness 1)

Five packaging members according to each of Examples and Comparative Examples were prepared.

The following operations were performed for each of the five packaging members.

Immediately after heating the opening and closing portion of the packaging member including the sealing material with the penetration member interposed in the opening and closing portion to the temperature the same as the body temperature, and closing the opening and closing so that the facing self-adhesive portions of the opening and closing portion touched each other, the packaging member was transferred to a room at 23°C and a relative humidity of 50%, and was left to stand for 1 hour to fix the opening and closing portion of the sealing member.

After the packaging member was left to stand for 1 hour, setting was made such that a pressure gauge was inserted into one of two pinchcocks of the packaging member and an air cinder having a capacity of 500 ml was inserted into the other so that air could be sent into the packaging member.

Then, using the air cinder, air was introduced so that the air pressure in the packaging member was 150 mmHg, and the mixture was stored for 24 hours under the conditions of 23°C and 50% relative humidity. Before and after storage, the pressure and the amount of air in the packaging member were measured.

The average value of the pressure inside the packaging member before and after storage obtained for each of the five packaging members according to each of Examples and Comparative Examples is taken as the pressure inside the packaging member before and after storage of the packaging members according to each of Examples and Comparative Examples.

In addition, the average value of the amount of air in the packaging member before and after storage obtained for each of the five packaging members according to each of Examples and Comparative Examples is taken as the amount of air in the packaging member before and after storage of the packaging members according to each of

Examples and Comparative Examples.

(Airtightness 2)

Immediately after heating the opening and closing portion of the packaging member including the sealing material with the penetration member interposed in the opening and closing portion to the temperature the same as the body temperature, and closing the opening and closing portion so that the facing self-adhesive portions of the opening and closing portion touched each other, the packaging member was transferred to a room at 23°C and a relative humidity of 50%, and was left to stand for 1 hour to fix the opening and closing portion of the sealing member.

After the packaging member was left to stand for 1 hour, both ends of the opening and closing portion of the sealing member were grasped with one hand, and whether or not the opening and closing portion was opened by applying a force in a direction from both the ends of the opening and closing portion to the center of the opening and closing portion was tested and evaluated according to the following evaluation criteria.

The stronger the force applied to open the opening and closing portion, the better the airtightness.

~ Evaluation Criteria ~

A: The opening and closing portion was able to open only in a case where a strong force was applied.
B: The opening and closing portion was able to open by applying a weak force.
C: The opening and closing portion was able to open without applying any force

[Table 2]

| | | | Example 1C | Example 2C | Example 3C | Example 4C | Example 5C | Example 6C | Example 7C | Example 8C | Reference Example | Comparative Example 1C | Comparative Example 2C | Comparative Example 3C | Comparative Example 4C |
|---|---|---|---|---|---|---|---|---|---|---|---|---|---|---|---|
| Self-adhesiveness member | Polymer | Kind | 4-MP | 4-MP | 4-MP | 4-MP | 4-MP | 4-MP | 4-MP | 4-MP | | PP | PP | PP | PP |
| | | tan δ local maximum value | 2.7 | 2.7 | 2.7 | 2.7 | 2.7 | 2.7 | 2.1 | 1.5 | | 0.08 | 0.08 | 0.08 | 0.08 |
| | | Temperature showing tan δ local maximum value (°C) | 30 | 30 | 30 | 30 | 30 | 30 | 35 | 40 | | 8 | 8 | 8 | 8 |
| | | Thickness (mm) | 80 | 120 | 120 | 80 | 120 | 120 | 120 | 120 | | 10 | 800 | 120 | 120 |
| | | Width (mm) | 15 | 15 | 15 | 15 | 15 | 15 | 15 | 15 | | 15 | 15 | 15 | 15 |
| | | Length (mm) | 40 | 50 | 50 | 40 | 50 | 50 | 50 | 50 | | 40 | 60 | 50 | 50 |
| Cushioning material | | Material | - | LDPE | LDPE | - | LOPE | LOPE | LOPE | LOPE | | - | - | LDPE | LDPE |
| | | Expansion ratio (times) | - | 32 | 32 | - | 32 | 32 | 32 | 32 | | - | - | 32 | 32 |
| | | Thickness (mm) | - | 8.5 | 8.5 | - | 8.5 | 8.5 | 8.5 | 8.5 | | - | - | 8.5 | 8.5 |
| Resin plate | | Material | - | - | HDPE | - | HDPE | ABS | HDPE | HDPE | No sealing member | - | - | Expanded 5 times | PET |
| | | Thickness (mm) | - | - | 0.5 | - | 0.8 | 1 | 0.8 | 0.8 | | - | - | 0.8 | 0.8 |
| | | Length (mm) | - | - | 70 | - | 65 | 50 | 65 | 65 | | - | - | 70 | 75 |
| | | Bending elastic modulus (Mpa) | - | - | 920 | - | 880 | 2400 | 880 | 880 | | - | - | 480 | 3200 |
| Maximum opening area (mm²) | | | 16 | 16 | 16 | 16 | 16 | 16 | 16 | 16 | | 16 | 16 | 16 | 16 |
| Penetration member | | Kind | Silicone tube | Silicone tube | Silicone tube | - | Silicone tube | Silicone tube | Silicone tube | Silicone tube | | Silicone tube | Silicone tube | Silicone tube | Silicone tube |
| | | Outer diameter (mm) | 4 | 6 | 8 | - | 6 | 4 | 6 | 6 | | 4 | 8 | 8 | 10 |

(continued)

| | | Exam-ple 1C | Exam-ple 2C | Exam-ple 3C | Exam-ple 4C | Exam-ple 5C | Exam-ple 6C | Exam-ple 7C | Exam-ple 8C | Refer-ence Ex-ample | Compara-tive Exam-ple 1C | Compara-tive Exam-ple 2C | Compara-tive Exam-ple 3C | Compara-tive Exam-ple 4C |
|---|---|---|---|---|---|---|---|---|---|---|---|---|---|---|
| Airtightness 1 | Initial amount of air (mL) | 1320 | 1390 | 1350 | 1360 | 1380 | 1360 | 1380 | 1380 | 1340 | 1360 | 1340 | 1390 | 1370 |
| | Amount of air after 24 hours (mL) | 1220 | 1290 | 1300 | 1320 | 1330 | 1320 | 1330 | 1320 | 850 | 1020 | 1090 | 1140 | 1170 |
| | Air pressure change (%) | -7.6% | -7.20 | -3.7% | -2 . 9% | -3.60 | -2 . 9% | -3.6% | -4.3% | -36.6% | -25% | -19% | -18% | -15% |
| | Initial air pressure (mmHa) | 150 | 150 | 150 | 150 | 150 | 150 | 150 | 150 | 150 | 150 | 150 | 150 | 150 |
| | Air pressure after 24 hours (mmHg) | 95 | 113 | 128 | 131 | 126 | 135 | 126 | 122 | 2 | 11 | 37 | 57 | 74 |
| | Air pressure change (%) | -36.7% | -24.7% | -14.7% | -12.7% | -16.0% | -10.0% | -16.0% | -18.7% | -98.7% | -92.7% | -75.3% | -62.0% | -50.7% |
| Airtightness 2 | Evaluation | A | A | A | A | A | A | B | B | - | C | C | C | C |

As shown in Table 2, in Examples using the sealing member including the self-adhesive member having a self-adhesive surface, in which an opening and closing portion is formed by causing the self-adhesive surfaces to face each other, the opening and closing portion is opened when the facing self-adhesive surfaces are separated from each other, and is closed when the facing self-adhesive surfaces are caused to adhere to each other, and the self-adhesive member contains a polymer satisfying the above Requirement 1, the airtightness of the opening and closing portion was excellent.

On the other hand, Comparative Examples 1 to 4 in which the temperature showing the local maximum value of the loss tangent (tan δ) was 8°C and the local maximum value of the loss tangent (tan δ) was 0.08 had inferior airtightness as compared with Examples.

The present application claims priority based on Japanese Patent Application No. 2020-048764 filed on March 19, 2020, Japanese Patent Application No. 2020-135699 filed on August 11, 2020, and Japanese Patent Application No. 2020-177619 filed on October 22, 2020, the entire disclosures of which are incorporated herein.

**Claims**

1.   A self-adhesive sheet comprising:

a 4-methyl-1-pentene-based polymer,
wherein in the self-adhesive sheet, at least one or more temperatures showing a local maximum value of a loss tangent (tan δ), which is obtained by dynamic viscoelasticity measurement under conditions of a temperature rising rate of 4 °C/min, a frequency of 1.59 Hz, and a strain amount of 0.1%, are present in a range of 10°C or higher and 100°C or lower, and the local maximum value of the loss tangent is 0.5 or more and 3.5 or less, and an arithmetic average roughness Ra on one surface of the self-adhesive sheet is in a range of 0.01 to 10 um, and a ten-point average roughness Rz is in a range of 0.1 to 50 um.

2.   The self-adhesive sheet according to claim 1,
wherein the 4-methyl-1-pentene-based polymer includes a constitutional unit derived from 4-methyl-1-pentene and a constitutional unit derived from an α-olefin having 2 to 20 carbon atoms other than the 4-methyl-1-pentene.

3.   The self-adhesive sheet according to claim 1 or 2,
wherein when a sum of a constitutional unit derived from 4-methyl-1-pentene and a constitutional unit derived from an α-olefin having 2 to 20 carbon atoms other than the 4-methyl-1-pentene is 100 mol%, a content of the constitutional unit derived from the 4-methyl-1-pentene is 10 mol% or more and 90 mol% or less.

4.   The self-adhesive sheet according to any one of claims 1 to 3,
wherein at least one or more temperatures showing the local maximum value of the loss tangent (tan δ) of dynamic viscoelasticity of the self-adhesive sheet are present in a range of 10°C or higher and 40°C or lower, and the local maximum value of the loss tangent is 0.8 or more and 3 or less.

5.   The self-adhesive sheet according to any one of claims 1 to 4,
wherein an average thickness of the self-adhesive sheet is in a range of 0.01 mm or more and 30 mm or less.

6.   The self-adhesive sheet according to any one of claims 1 to 5,
wherein the arithmetic average roughness Ra on one surface of the self-adhesive sheet is 3.5 um or less.

7.   The self-adhesive sheet according to any one of claims 1 to 6,
wherein the self-adhesive sheet is processed into one or two or more shapes selected from a parallel linear shape, a wavy shape, a grid shape, a mesh shape, a honeycomb shape, and a dotted shape in an in-plane direction.

8.   A fixing member comprising:
a laminated portion in which a plurality of the self-adhesive sheets according to any one of claims 1 to 7 are in contact with each other.

9.   A touch fastener comprising:
the self-adhesive sheet according to any one of claims 1 to 8 as an attachment and detachment surface.

10.  A wiring board comprising:

a self-adhesive sheet; and
a wiring,
wherein the sheet contains a 4-methyl-1-pentene-based polymer and satisfies the following conditions,
wherein (Conditions)
in the self-adhesive sheet, one or more temperatures showing a local maximum value of a loss tangent (tan δ), which is obtained by dynamic viscoelasticity measurement under conditions of a temperature rising rate of 4 °C/min, a frequency of 1.59 Hz, and a strain amount of 0.1%, are present in a range of 10°C or higher and 100°C or lower, and the local maximum value of the loss tangent is 0.5 or more and 3.5 or less.

**11.** The wiring board according to claim 10,

wherein the wiring is electrically connected to an electrode, and
the self-adhesive sheet covers the wiring and has an opening which exposes the electrode.

**12.** The wiring board according to claim 10 or 11, which has deformability.

**13.** The wiring board according to any one of claims 10 to 12,
wherein the self-adhesive sheet has insulating properties.

**14.** The wiring board according to any one of claims 10 to 13,
wherein the wiring is formed of a conductive ink.

**15.** The wiring board according to any one of claims 10 to 14,
wherein the wiring board has a sucker-shaped recess portion that is gently curved in a part of an outer surface of the self-adhesive sheet.

**16.** The wiring board according to any one of claims 10 to 15,
wherein in the wiring board, a thickness of an outer edge portion is smaller than that of a central portion.

**17.** The wiring board according to any one of claims 10 to 16,
wherein the wiring board is used so that an outer surface on a self-adhesive sheet side comes into close contact with a skin of a living body.

**18.** An electronic device comprising:

the wiring board according to any one of claims 10 to 17;
an electrode which is exposed to an outer surface of the self-adhesive sheet; and
an electronic component which is electrically connected to the wiring.

**19.** A sealing member comprising:

a self-adhesive member having a self-adhesive surface and formed of a self-adhesive sheet satisfying the following Requirement 1,
wherein an opening and closing portion is formed by causing the self-adhesive surfaces to face each other, and the opening and closing portion is opened when the facing self-adhesive surfaces are separated from each other, and is closed when the facing self-adhesive surfaces are caused to adhere to each other,
wherein (Requirement 1)
at least one or more temperatures showing a local maximum value of a loss tangent (tan δ), which is obtained by dynamic viscoelasticity measurement under conditions of a temperature rising rate of 4 °C/min, a frequency of 1.59 Hz, and a strain amount of 0.1%, are present in a range of 10°C or higher and 100°C or lower, and the local maximum value of the loss tangent is 0.5 or more and 3.5 or less.

**20.** The sealing member according to claim 19,
wherein the 4-methyl-1-pentene-based polymer includes a constitutional unit derived from 4-methyl-1-pentene and a constitutional unit derived from an α-olefin having 2 to 20 carbon atoms other than the 4-methyl-1-pentene.

**21.** The sealing member according to claim 19 or 20, further comprising:

a resin plate disposed on a side opposite to the self-adhesive surface with respect to the self-adhesive member,
wherein the resin plate satisfies the following Requirements 2 to 4,
wherein (Requirement 2)
the resin plate has a bending elastic modulus of 500 MPa to 2500 MPa (JIS K 7171),
wherein (Requirement 3)
the resin plate has a thickness of 500 um to 3000 um, and
wherein (Requirement 4)
the resin plate has hinge structures at both ends.

22. The sealing member according to any one of claims 19 to 21, further comprising:
a cushioning material provided between the self-adhesive member and the resin plate.

23. The sealing member according to any one of claims 19 to 22,
wherein one or two or more selected from the group consisting of a tube, a catheter, a power cable, a communication cable, and a wire penetrate the opening and closing portion.

24. A packaging member comprising:

the sealing member according to any one of claims 19 to 23; and
a packaging material.

Fig.1

(a)

9a

(b)

9b

Fig.2

10(11)

Fig.3

Fig.4

(a)

(b)

(c)

Fig.5

Fig.6

Fig.7

Fig.8

4    1

2

3

10(11)

Fig.9

Fig.10

Fig.11

a7

a6

a10

a9

a8

Fig.12

T

a6

a7

a10

a9

a11

Fig.13

Fig.14

Fig.15

Fig.16

Fig.17

a14

a10

a7

a9

a12

**INTERNATIONAL SEARCH REPORT**

| International application No. |
| --- |
| PCT/JP2021/011183 |

**A. CLASSIFICATION OF SUBJECT MATTER**

A44B 18/00(2006.01)i; B32B 27/00(2006.01)i; B32B 27/32(2006.01)i; B65D 65/00(2006.01)i; C08F 210/14(2006.01)i; C09J 123/02(2006.01)i; C09J 123/20(2006.01)i; C08J 5/00(2006.01)i; C09J 7/26(2018.01)i; C09J 7/38(2018.01)i; H05K 1/02(2006.01)i

FI:    C09J123/20; A44B18/00; B32B27/00 M; B32B27/32; H05K1/02 J; C08F210/14; B65D65/00 A; C09J7/26; C09J123/02; B32B27/00 J; C08J5/00 CES; C09J7/38; H05K1/02 B

According to International Patent Classification (IPC) or to both national classification and IPC

**B. FIELDS SEARCHED**

Minimum documentation searched (classification system followed by classification symbols)

A44B18/00; B32B27/00; B32B27/32; B65D65/00; C08F210/14; C09J123/02; C09J123/20; C08J5/00; C09J7/26; C09J7/38; H05K1/02

Documentation searched other than minimum documentation to the extent that such documents are included in the fields searched

| | |
| --- | --- |
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2013-194132 A (MITSUI CHEMICALS, INC.) 30 September 2013 (2013-09-30) claims, examples 1-6 | 1-24 |
| Y | JP 2016-14129 A MITSUI CHEMICALS, INC.) 28 January 2016 (2016-01-28) claims, paragraphs [0009], [0020], [0080], examples 1-7 | 1-24 |
| Y | WO 2016/047321 A1 (TORAY ADVANCED FILM CO., LTD.) 31 March 2016 (2016-03-31) claims, paragraphs [0015]-[0022], examples 1-9 | 1-24 |

☒ Further documents are listed in the continuation of Box C.    ☒ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 03 June 2021 (03.06.2021) | 15 June 2021 (15.06.2021) |

| Name and mailing address of the ISA/ | Authorized officer |
| --- | --- |
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

International application No.

PCT/JP2021/011183

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2018-119138 A (TORAY INDUSTRIES, INC.) 02 August 2018 (2018-08-02) paragraphs [0014]-[0015] | 1-24 |
| Y | JP 8-308611 A (NITTO DENKO CORP.) 26 November 1996 (1996-11-26) claims | 8-9 |
| Y | JP 2017-38931 A (THE UNIVERSITY OF ELECTRO-COMMUNICATIONS) 23 February 2017 (2017-02-23) claims, paragraphs [0032], [0047], [0093] | 10-18 |
| Y | WO 2012/042878 A1 (TERUMO CORP.) 05 April 2012 (2012-04-05) claims, paragraphs [0036]-[0040], [0058] | 10-18 |
| Y | JP 2001-26073 A (INOAC CORP.) 30 January 2001 (2001-01-30) claims, paragraphs [0010], [0020] | 19-24 |
| Y | JP 2018-532538 A (SABAN VENTURES PTY LIMITED) 08 November 2018 (2018-11-08) claims, paragraphs [0018], [0036] | 19-24 |
| Y | JP 2001-130598 A (DAIWA GRAVURE CO., LTD.) 15 May 2001 (2001-05-15) claims, paragraph [0007] | 19-24 |
| Y | JP 2005-238633 A (MITSUI CHEMICALS, INC.) 08 September 2005 (2005-09-08) claims, paragraph [0015] | 19-24 |

Form PCT/ISA/210 (continuation of second sheet) (January 2015)

INTERNATIONAL SEARCH REPORT

Information on patent family members

International application No.

PCT/JP2021/011183

| Patent Documents referred in the Report | Publication Date | Patent Family | Publication Date |
|---|---|---|---|
| JP 2013-194132 A | 30 Sep. 2013 | (Family: none) | |
| JP 2016-14129 A | 28 Jan. 2016 | (Family: none) | |
| WO 2016/047321 A1 | 31 Mar. 2016 | CN 106795374 A<br>KR 10-2017-0063508 A | |
| JP 2018-119138 A | 02 Aug. 2018 | (Family: none) | |
| JP 8-308611 A | 26 Nov. 1996 | (Family: none) | |
| JP 2017-38931 A | 23 Feb. 2017 | (Family: none) | |
| WO 2012/042878 A1 | 05 Apr. 2012 | US 2013/0274566 A1<br>claims, paragraphs<br>[0097]-[0101], [0147]<br>EP 2623026 A<br>CN 103153179 A<br>KR 10-2014-0024241 A | |
| JP 2001-26073 A | 30 Jan. 2001 | (Family: none) | |
| JP 2018-532538 A | 08 Nov. 2018 | US 2018/0310911 A1<br>claims, paragraphs<br>[0018], [0036]<br>EP 3367910 A1<br>CN 108348216 A<br>KR 10-2018-0090268 A | |
| JP 2001-130598 A | 15 May 2001 | US 6419393 1<br>claims, column 1,<br>line 65 to column 2,<br>line 8<br>EP 1616805 A1 | |
| JP 2005-238633 A | 08 Sep. 2005 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018070676 A
- JP 2020047818 A
- JP 2020010052 A
- WO 0153369 A
- WO 01027124 A
- JP H03193796 A
- JP H0241303 A
- WO 2011055803 A
- JP 2020048764 A
- JP 2020135699 A
- JP 2020177619 A